# EUROPEAN PATENT SPECIFICATION

(11) **EP 4 533 919 B1**
(45) Date of publication and mention of the grant of the patent: **04.11.2026**
(21) Application number: 24827705.5
(22) Date of filing: 18.07.2024
(51) Int. Cl.: H05K 7/20, H05K 1/02, H10W 40/47

(54) **INTERNAL RECIRCULATION COOLING MODULE**
KÜHLMODUL MIT INTERNER RÜCKFÜHRUNG
MODULE DE REFROIDISSEMENT À RECIRCULATION INTERNE

(30) Priority: 18.07.2023 US 202363527517 P
(43) Date of publication of application: 09.04.2025
(73) Proprietor: Jetcool Technologies Inc., Littleton, MA 01460 (US)
(72) Inventor: HABER, Ludwig C., Littleton, Massachusetts 01460 (US); BOGGIO, Cameron, Littleton, Massachusetts 01460 (US); LA FOSSE, Andy, Littleton, Massachusetts 01460 (US); FOX, David, Littleton, Massachusetts 01460 (US); BALLERSTEDT, Robert, Littleton, Massachusetts 01460 (US)
(74) Representative: Appleyard Lees IP LLP
(86) International application number: PCT/US2024/038605
(87) International publication number: WO 2025/019707

(56) References cited:
- WO-A1-2005/117108
- KR-A- 20210 090 231
- US-A- 5 841 634
- US-A1- 2012 063 085
- US-A1- 2021 265 240
- US-A1- 2021 320 050
- US-A1- 2023 048 500

## Description

### Field of the Invention

The present invention relates generally to the field of liquid cooling modules for data centers, servers, power inverters and other liquid cooling module compute assemblies, and more particularly to micro-convective jet impingement liquid cooling devices and methods.

### Related Art

The cooling performance of direct-to-chip single phase liquid cooling (DLC) devices is typically measured in terms of heat transfer coefficients. Impingement cooling modules produce very high local heat transfer coefficients. Performance of cooling modules utilizing impingement cooling are driven by both flow rate and pressure drop. Relative to other more established cooling technologies, (e.g. microchannel), impingement cooling performs at its best when the cooling module flow rate is 2x-4x higher than established cooling technologies. There are inherent advantages in employing impingement cooling modules, even with the relatively higher flow consumption such as a more even processor temperature distribution and the absence of caloric thermal resistance, among others.

However, the existing cooling infrastructure in a given application area may be such that a 2x - 4x increase in flow rate cannot be supported. Peak performance of jet impingement cooling modules can therefore not be achieved in these environments. Jet impingement modules would therefore benefit from the ability to reduce flow requirements to ensure a more optimal impingement performance is obtained, even at lower flow rates. WO2005/117108A1 describes a cooling arrangement provided in which a matrix is arranged to provide a cascade path incorporating chambers such that spent coolant which has impinged a target surface for cooling does not create a detrimental cross flow inhibiting subsequent downstream coolant jet impingement for cooling effect. US5841634A1 describes a liquid-cooled heat-sink including a cooling housing defining a cooling chamber where the chamber is positioned adjacent to a semi-conductor device or devices to be cooled.

### Summary Of The Invention

Embodiments of the present invention provide improved cooling modules and methods for cooling heat-generating electronic components attached to printed circuit boards found in servers and other data processing equipment. The improved cooling modules and methods are configured to recirculate the liquid coolant fluid inside the cooling modules so that the same liquid cooling fluid impinges the surfaces of the heat-generating electronic components (or cooling plates in thermal communication with the heat-generating electronic components) multiple times before exiting the cooling module, thereby allowing a given flow of coolant fluid to be re-used several times over. With each re-use of the coolant fluid, the flow rate demand drops. For example, a single recirculation of the coolant fluid in a cooling module constructed and operating in accordance with the devices and techniques described herein typically reduces the flow rate requirement of that cooling module by approximately 50% without a significant decrease in cooling performance. A triple recirculation of the coolant fluid inside the cooling module typically reduces the flow rate requirement by 67%, and so on. Beneficially, internal recirculation, implemented according to the current invention, does not increase the number of external seals required, limits pressure losses in internal manifolding and allows priority cooling areas on the chipset to be addressed first by correct staging of the impingement areas internal to the cooling module.

In general, embodiments of the present invention provide cooling modules with reduced flow demand by implementing internal recirculation of the liquid coolant fluid inside the cooling module so that the liquid coolant fluid impinges on the surfaces to be cooled multiple times before the liquid coolant fluid exits the cooling module. Internal recirculation allows the discharge fluid from a given section within the cooling module to be routed to the inlet of a second section without leaving the cooling module housing. This technique of efficiently collecting and rerouting coolant fluid that has already impinged on the cooling surface permits the bulk of the liquid coolant fluid to remain within the primary external seal boundary of the cooling module for a longer time while its cooling potential can still be put to effective use. Thus, the benefits of using embodiments of the present invention include, without limitation:
1) Allowing re-use of the coolant fluid several times, significantly cutting flow demand.
2) Efficiently routing the coolant fluid to minimize manifolding pressure drops.
3) Avoiding the additional external seal failure points and the additional pressure drops associated with externally recirculating the coolant fluid.

The coolant fluid passing through cooling modules constructed and operated according to embodiments of the present invention is internally rerouted a number of times after impingement so that it can be "re-used" multiple times to cool multiple sections of a cooling surface. The coolant fluid is also accelerated against the surface to be cooled several times using micro-convective nozzle arrays. But rather than being expelled from the cooling module after a single impingement, the coolant fluid is re-captured and re-accelerated through additional micro-convective nozzle arrays in one or more additional stages. By connecting multiple different sections of micro-convective nozzle arrays in series, the flow rate is reduced. In some embodiments the multiple different sections of nozzle arrays may be connected in series and in parallel with each other.

The devices and techniques disclosed herein may be implemented in both direct cooling modules and indirect cooling modules. Direct cooling modules apply the coolant directly to the surface of the heat source to cause heat transfer. Indirect cooling modules apply the coolant to a plate that is part of the cooling module where the plate is in thermal contact with the heat source to cause heat transfer.

In one embodiment, the invention provides a cooling module, wherein the cooling module includes a jet plate, a housing, a ceiling between the jet plate and the housing, a base plate, a fastening system and a fastening system for attaching the cooling module to a circuit board (or server) containing heat-generating electronic components. The jet plate has an upper face, a lower face, a first segment that includes a first array of microjet nozzles extending through the jet plate from the upper face of the jet plate to the lower face of the jet plate, and a second segment that includes second array of microjet nozzles extending through the jet plate from the upper face of the jet plate to the lower face of the jet plate. The ceiling disposed between the jet plate and the housing includes a first ceiling-mounted boundary extending from the ceiling to the upper face of the jet plate and a second ceiling-mounted boundary extending from the ceiling to the upper face of the jet plate. The base plate comprises a cooling surface, a first cooling surface-mounted boundary extending from the cooling surface to the lower face of the jet plate, and a second cooling surface-mounted boundary extending from the cooling surface to the lower face of the jet plate.

The jet plate, the ceiling, the cooling surface of the base plate, the first ceiling-mounted boundary, the second ceiling-mounted boundary, the first cooling surface-mounted boundary and the second cooling surface-mounted boundary are all arranged to define a first inlet plenum located between the ceiling and the first array of microjet nozzles, a second inlet plenum located between the ceiling and the second array of microjet nozzles, a first impingement volume located between the first array of microjet nozzles and the cooling surface, a second impingement volume located between the second array of microjet nozzles and the cooling surface, and a first couch passage fluidly connecting the first impingement volume to the second inlet plenum.

The fastening system, which may include screws, pins or a tensioner plate, for example, attaches the cooling module to the circuit board, which has one or more heat-generating electronic components affixed thereto. In one embodiment, the fastening system attaches the cooling module to the circuit board such that the cooling surface of the base plate will be in direct thermal communication with the one or more heat-generating electronic components on the circuit board. In this configuration, the cooling surface of the base plate is able to absorb heat generated by heat-generating electronic components while the circuit board is in operation.

The cooling module also includes an inlet fitting attached to the housing, the inlet fitting being configured to admit into the cooling module a pressurized coolant fluid transferred from an external source, such as an external pump or central distribution unit (CDU). An inlet flow channel inside the cooling module carries the pressurized coolant fluid from the inlet fitting to the first inlet plenum. When the pressurized coolant fluid coolant fluid enters the first inlet plenum, the first array of microjet nozzles in the first segment of the jet plate is configured to receive the pressurized coolant fluid from the first inlet plenum, and accelerate the pressurized coolant fluid while directing the accelerated and pressurized coolant fluid to flow into the first impingement volume below the jet plate at a high velocity to strike a first portion of the cooling surface of the base plate, thereby removing the heat that the first portion of the cooling surface has absorbed from said one or more heat-generating electronic components.

At this point, the couch passage is configured to carry some of the pressurized coolant fluid that struck the first portion of the cooling surface out of the first impingement volume and into the second inlet plenum. Then the second array of microjet nozzles in the jet plate draws the pressurized coolant fluid from the second inlet plenum, accelerates the pressurized coolant fluid, and directs the accelerated and pressurized coolant fluid to flow into the second impingement volume at high velocity to strike a second portion of the cooling surface of the base plate, thereby removing the heat that the second portion of the cooling surface has absorbed from said one or more heat-generating electronic components.

In preferred embodiments, the cooling module of the present invention also includes one or more effluent collection passages to capture some of the pressurized coolant fluid in the first and second impingement volumes and route the captured pressurized coolant fluid to an outlet fitting attached to the housing for discharge from the cooling module.

Notably, the ceiling may, or may not, be manufactured as an integral component of the housing. In some embodiments, cooling modules of the present invention may include an interstitial plate disposed between the housing and the jet plate, and the ceiling is integrated into the interstitial plate instead of the housing.

In another embodiment, the base plate of the cooling module has an opening on the bottom side, instead of a cooling surface, which permits the coolant fluid accelerated by the microjet arrays in the jet plate to impinge directly on the surfaces of the heat-generating electronic components multiple times, instead of impinging on a cooling surface in thermal contact with the heat-generating electronic components. After impingement the first time, the cooling fluid is then carried by the couch passage to a downstream inlet plenum to be accelerated and directed to impinge directly on other portions of the heat-generating for a second (third or fourth) time by a second (third or fourth) microjet nozzle array in the jet plate.

In still another embodiment, a method for cooling one or more heat-generating electronic components attached to a circuit board is provided. Step 1 in the method is providing a cooling module comprising a jet plate, a housing, a ceiling disposed between the jet plate and the housing, a base plate having a cooling surface, and a fastening system for fastening the cooling module to the circuit board. For this step, the jet plate comprises a first segment that includes a first array of microjet nozzles extending through the jet plate, and a second segment that includes second array of microjet nozzles extending through the jet plate. The jet plate, the ceiling, the cooling surface of the base plate, the first ceiling-mounted boundary, the second ceiling-mounted boundary, the first cooling surface-mounted boundary and the second cooling surface-mounted boundary are all arranged to define a first inlet plenum located between the ceiling and the first array of microjet nozzles, a second inlet plenum located between the ceiling and the second array of microjet nozzles, a first impingement volume located between the first array of microjet nozzles and the cooling surface, a second impingement volume located between the second array of microjet nozzles and the cooling surface, and a first couch passage fluidly connecting the first impingement volume to the second inlet plenum.

Step 2 is using the fastening system to attach the cooling module to the circuit board so that the cooling surface of the base plate will be in thermal communication with said one or more heat-generating electronic components on the circuit board and absorbs heat generated by said one or more heat-generating electronic components while the circuit board is in operation. Step 3 of the method is connecting an external source for pressurized coolant fluid to an inlet port on the housing of the cooling module. Step 4 is transmitting pressurized coolant fluid received at the inlet port into the first inlet plenum of the jet plate.

In step 5, the first array of microjet nozzles in the first segment of the jet plate receives the pressurized cooling fluid from the first inlet plenum, accelerates the pressurized coolant fluid and directs the accelerated and pressurized coolant fluid to flow into the first impingement volume at high velocity to strike a first portion of the cooling surface of the base plate, thereby removing the heat that the first portion of the cooling surface has absorbed from said one or more heat-generating electronic components. Typically, but not necessarily, the coolant leaves via the boundaries of the impingement volume. In step 6, the couch passage in the cooling module transmits at least some of the pressurized coolant fluid that struck the first portion of the cooling surface from the first impingement volume to the second inlet plenum. And finally, in step 6, the second array of microjet nozzles in the jet plate receives the pressurized coolant fluid from the second inlet plenum, accelerates the pressurized coolant fluid and then directs the accelerated and pressurized coolant fluid to flow into the second impingement volume at high velocity to strike a second portion of the cooling surface of the base plate, without permitting the pressurized coolant fluid to exit the cooling module before entering the second inlet plenum, thereby removing the heat that the second portion of the cooling surface has absorbed from said one or more heat-generating electronic components.

### Brief Description of the Figures

The accompanying drawings, which are incorporated in and constitute part of the specification, illustrate preferred embodiments of the invention, and, together with the description, serve to explain the principles of the present invention. In the drawings, like reference numbers indicate identical or functionally similar elements. Additionally, the leftmost digit(s) of a reference number identifies the drawing in which the reference number first appears.
FIG. 1 shows a prior art cooling module in cross-section. The low temperature inlet coolant has access to the entire jet plate and is accelerated through the jet plate towards the surface to be cooled (direct module) or the base plate (indirect module). The coolant, increased in temperature through heat transfer, is collected and flows to the outlet.
FIGs. 2A, 2B and 2C show an example of an internal recirculation cooling module in cross-section according to one embodiment of the current invention. In this example, the cooling module has four stages.
FIG. 3 shows how the flow path (A) for a conventional, prior art cooling module differs from the flow path (B) of a cooling module equipped with internal recirculation according to embodiments of the present invention.
FIG. 4 shows that the segmentation of the sections of jet plate within a given cooling module can be arbitrary.
FIG. 5 shows a schematic representation of a surface segmentation where the initial central impingement area is connected to two separate subsequent jet plate sections, both of which route their effluent into a common annular collection passage to flow to the outlet.
FIGs. 6A and 6B show isometric cross-sectional views of an indirect cooling module 600 with internal recirculation constructed according to one embodiment of the present invention (Example A)..
FIG. 7 shows the same cooling module (Example A) with housing removed to better identify the couch passages between the impingement volumes of each jet plate section and the inlet side of the downstream section. For this example, the couch passages repeat on two ends of the cooling module (A and B).
FIG. 8 shows an exploded view of another example (Example B) of a cooling module constructed according to another embodiment of the present invention, with the housing removed in order to better illustrate some of the internal components.
FIG. 9 shows a partial section view of the cooling module 900 (Example B) shown in the exploded view of FIG. 8.
FIG. 10 shows a cooling module assembly constructed according to the invention described herein (Example C).
FIG. 11 shows an exploded view of Example C of an implementation of the present invention. The base plate contains a number of channel features to help form the couch passages together with the jet plate and housing.
FIG. 12 shows a partial top view of the exemplary cooling module assembly shown in FIG. 10 (Example C).
FIG. 13 further clarifies the flow path in the exemplary cooling module shown in FIGs. 10 - 12 .
FIG. 14 shows an exploded view of another cooling module (Example D) constructed in accordance with an embodiment of the present invention. The cooling module shown mounts directly to the heat source and is therefore considered to be a direct (contact) cooling module.
FIG. 15 shows the flow arrangement for the direct contact cooling module (Example D) shown in FIG. 14.
FIGs. 16A and 16B show partial sectional views of the direct contact cooling module (Example D) shown in FIG. 14.

### Detailed Description Of The Exemplary Embodiments

Reference will now be made in detail to the preferred embodiments of the invention, examples of which are illustrated in the accompanying drawings. Notably, the figures and examples below are not meant to limit the scope of the present invention or its embodiments or equivalents. The scope is defined by the appended claims. For purposes of this detailed discussion, unless specifically stated otherwise, the terms "section" and "segment" are used interchangeably, and therefore may be considered to have the same meanings.

### Overview of the Present Invention

The invention uses the geometric structures of the jet plate, the ceiling and the base plate to divide the internal chambers of the cooling module into sections so that the flow passes through at least two sections in series where the discharge from one or more sections is routed to the inlet of a subsequent section within the cooling module. By causing the same coolant fluid to be put in contact with the cooling surface (base plate cooling surface or heat source) multiple times, the flow rate consumption of the cooling module is significantly reduced. By not permitting the coolant fluid to leave the external seal boundary of the cooling module to re-chill and recirculate it, the number of external seals required is reduced and the total pressure drop of the recirculating cooling module is reduced because the flow path is more compact.

Many internal manifolding possibilities exist to implement the invention in the framework of both direct and indirect cooling modules. The flow passage that collects the effluent from one section of the cold plate and routes it to the inlet side of the following section is referred to as the couch passage. The couch passage serves to isolate the effluent area of the originating jet plate section from the effluent section of any downstream jet plate sections. The couch passage may also be sealed to prevent coolant fluid flowing past the next jet plate section. The couch passage is formed using a combination of surfaces associated with other internal elements of the cooling module. Thus, the couch passage may be formed, for example, from the walls and structures of:
A) The jet plate (possibly with cutouts), the ceiling, and the base plate.
B) The jet plate (possibly with cutouts), the interstitial plate, and the base plate.
C) The jet plate (possibly with cutouts), the housing, and the interstitial plate.
D) The jet plate (possibly with cutouts), and the interstitial plate.
E) The jet plate (possibly with cutouts), boundaries extending from the ceiling, the interstitial plate and the base plate.

Each segment of the jet plate includes a micro-jet nozzle array configured to draw coolant fluid from an adjacent inlet plenum, and then accelerate the coolant fluid to flow at high velocity into and through an associated impingement volume beneath the jet plate so that the accelerated coolant fluid will impinge on a portion of cooling surface, which may comprise a cooling surface on the base plate of the cooling module or a cooling surface on the heat source, and thereby promote heat transfer from the heat source to the coolant fluid.

If present, the interstitial plate serves to aid in guiding the flow from the outlet of one segment to the inlet plenum of the next segment. Modern manufacturing technologies can allow the jet plate, the ceiling, or both, to be constructed as an integral component of the interstitial plate. Cooling performance may be improved by sealing the joints between the jet plate and the housing, the interstitial plate, the ceiling and/or the base plate using either a gasket, an adhesive, or a welding procedure.

The fastening system can be incorporated directly into the housing, meaning the housing has mounting holes that connect the cooling module to the heat source. The fastening system can also use a separate structure, sometimes referred to as a tensioner plate, which transmits the fastener mounting force from the board that the heat generating component is mounted to, to the housing.

Additional geometric structures (e.g., walls or boundaries) may be added to the direct cooling modules, the indirect cooling modules, or both, to assist in the formation of couch passages beneath the jet plate to help ensure flow does not short circuit between various effluent sections. The additional geometric structures tend to simplify the geometry needed for the base plate, thus reducing the cost of manufacture and assembly. An optional assembly of the cooling module and an implementation of the present invention in a cooling module can be facilitated by constructing the housing in two parts, the two parts being fastened, adhered, or welded together.
In addition, it may be beneficial to manufacture the multiple segments of the jet plate into separate pieces and have these separate pieces be held within the assembly, rather than using one contiguous jet plate.

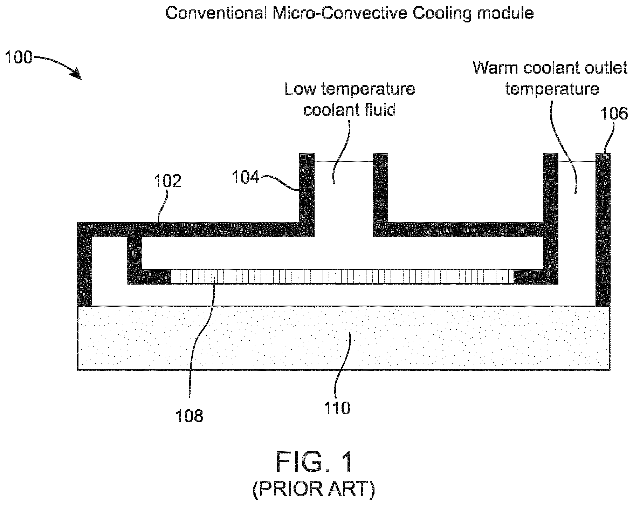

Turning to the figures, FIG. 1 shows a prior art cooling module 100 in cross-section. As shown in FIG. 1, the prior art cooling module 100 typically comprises a housing 102, an inlet 104, an outlet 106 and a jet plate 108. The housing 102 is attached to the surface to be cooled 110. The low temperature coolant enters the inlet 104 and has access to the entire jet plate 108 and is accelerated through the jet plate 108 towards the surface to be cooled 110 (direct module) or the base plate (indirect module). The temperature of the coolant fluid increases due to the heat transfer resulting from the contact with the cooling surface 110. The coolant fluid is collected and flows to the outlet 106 to be discharged from the cooling module 100.

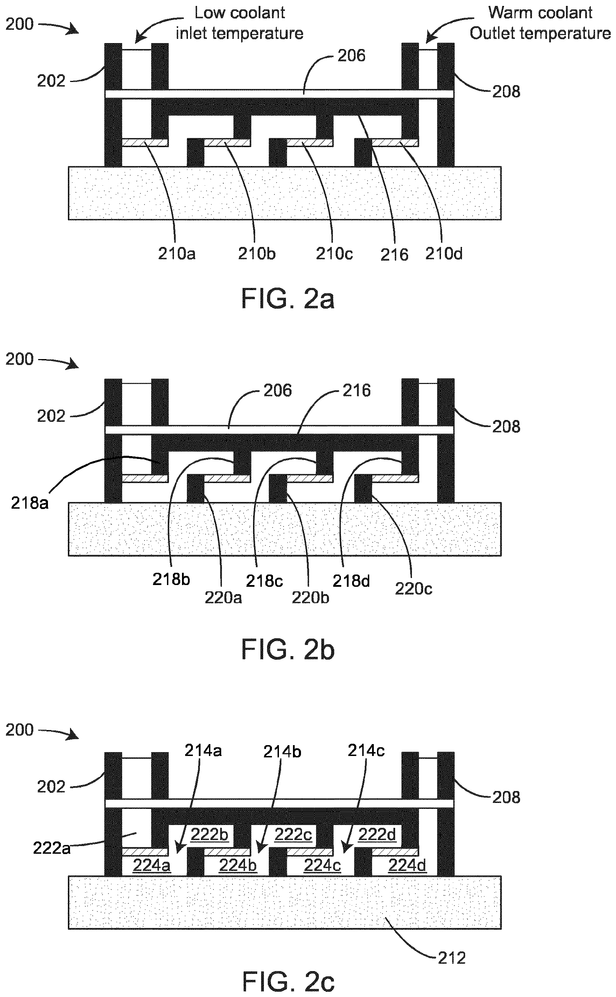

FIGs. 2A, 2B and 2C show an example of an internal recirculation cooling module 200 in cross-section according to one embodiment of the current invention. In this example, the cooling module 200 has four stages, meaning that the same coolant fluid is accelerated four separate times through four separate segments 210a - 210d of a jet plate that each address a different area on the surface to be cooled 212. The surface to be cooled 212 may comprise a base plate in thermal contact with a surface of one or more heat-generating electronic devices, wherein the base plate is a component of the cooling module 200. In this configuration, the cooling module 200 is referred to as an "indirect" cooling module. Alternatively, the surface to be cooled 212 may comprise the heat-generating electronic device itself, in which case the cooling module 200 may be referred to as a "direct" cooling module.

As shown best in FIG. 2A, the cooling module 200 comprises an inlet port 202 connected to a housing 206, an outlet port 208 connected to the housing 206, and a segmented jet plate 210a - 210d. The cooling module 200 also includes a ceiling 216 located on the inside of the top wall of the housing 206. As shown best in FIG. 2B, the ceiling 206 has a set of ceiling-mounted boundaries 218a - 218d (i.e., walls) extending from the ceiling 216 down to the upper faces of each one of the different segments 210a - 210d of the jet plate. If the cooling surface is a base plate (as in the indirect cooling version of the cooling module), then the cooling surface 212 has a set of cooling surface-mounted boundaries 220a - 220d extending from the base plate 212 up to lower faces 222 of the jet plate 210a - 210d.

The shapes, arrangement and relative positions of the jet plate segments 210a - 210d, ceiling 216, ceiling mounted boundaries 218a - 218c, the cooling surface 212 and the cooling surface-mounted boundaries 220a - 220c altogether serve to define four inlet plenums 222a - 222d located above the jet plate segments 210a - 210d, four impingement volumes 224a - 224d located below the jet plate segments 210a - 210d, and three couch passages 214a - 214c. See FIG. 2C. The couch passages 214a - 214c are configured to fluidly connect the exits of impingement volumes 224a - 224c to the entries of inlet plenum 222b - 222d in the cooling module 200, so that cooling fluid that has already entered the impingement volumes 224a - 224c to impinge on different portions of the cooling surface 212 will next be routed to the inlet plenums 222b - 222d, where the coolant fluid will be drawn into and accelerated by subsequent micro-jet arrays in the jet plate segments 210b - 210d.

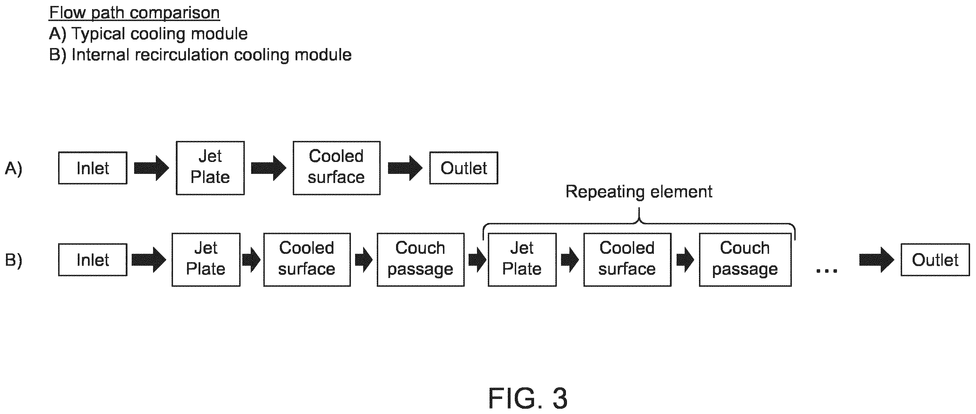

FIG. 3 shows how the flow path (A) for a conventional, prior art cooling module differs from the flow path (B) of a cooling module equipped with internal recirculation according to embodiments of the present invention. The couch passages link the impingement volumes below each segment of the jet plate with the inlet plenums of the subsequent sections of jet plate. Although it may be more efficient to form the couch passages by controlling by the shapes, arrangement, and relative positions of the boundaries extending from the ceiling and the cooling surface in the cooling module, it is to be understood that, in alternative embodiments of the present invention, the couch passages may comprise physical tubes or conduits (independent from the boundaries extending from the ceiling and cooling surface).

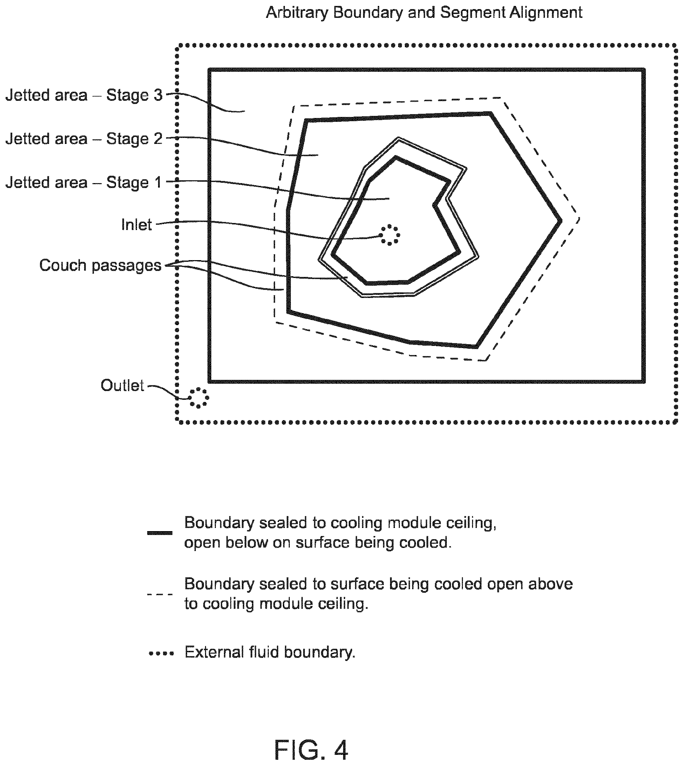

FIG. 4 illustrates that the apportioning of the segments of jet plate within a given cooling module can be arbitrary. Here, a central inlet is connected from a central jet plate section to subsequent ring-like segments to an annular outlet collection passage and finally to an outlet.

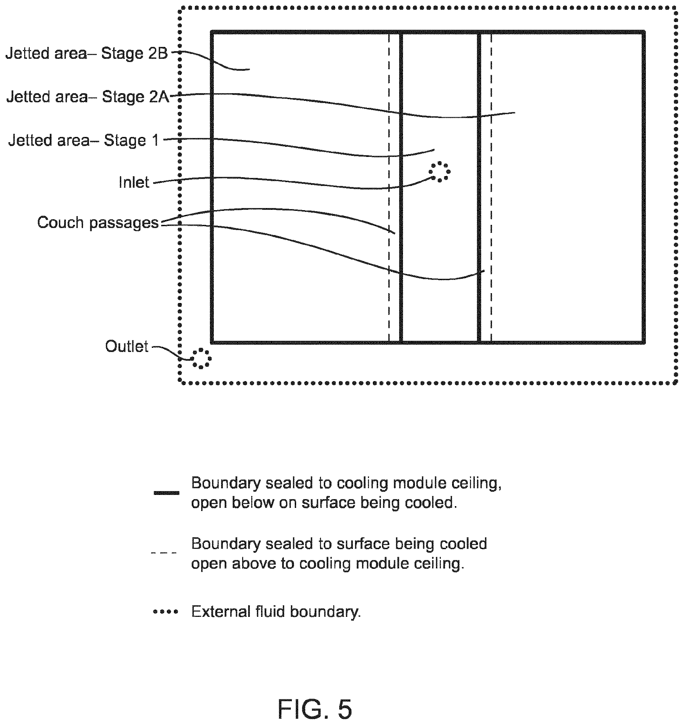

FIG. 5 shows a schematic representation of a surface apportioning where the initial central impingement area is connected to two separate subsequent jet plate sections which then both route their effluent into a common annular collection passage to route flow to the outlet. The schematic shows that not all jet plate sections must be connected in series.

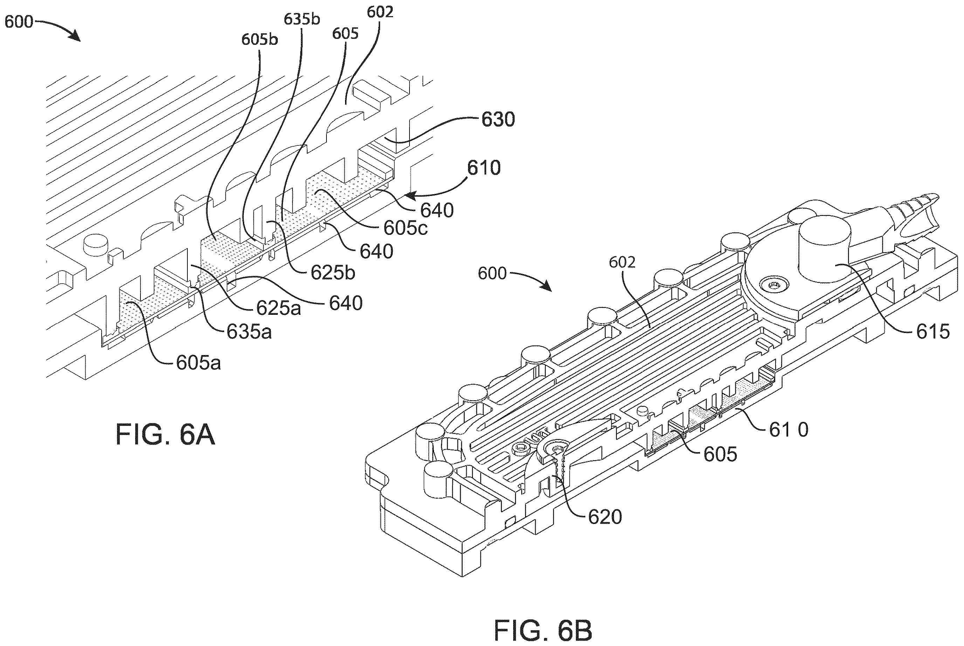

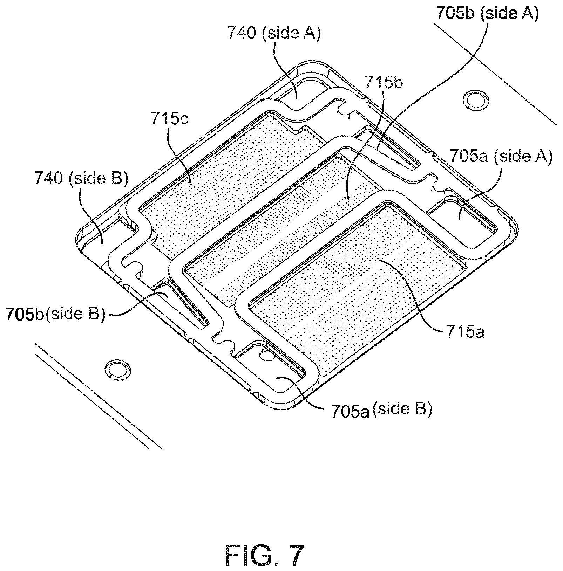

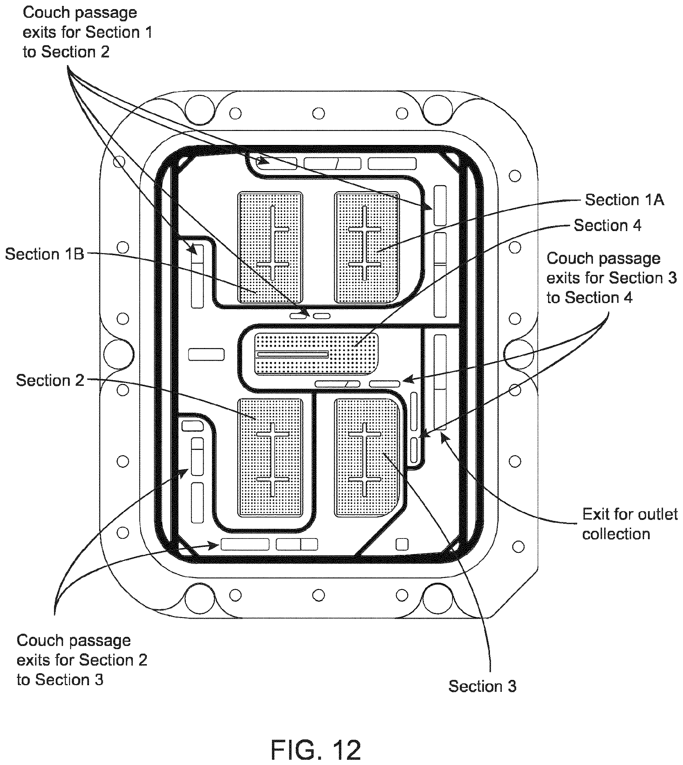

FIGs. 6A and 6B show isometric cross-sectional views of an indirect cooling module 600 with internal recirculation constructed according to one embodiment of the present invention (Example A). The cooling module 600 has a housing 602, a jet plate 605, a base plate 610, an inlet 615 and an outlet 620. The jet plate 605 is apportioned into three separate segments 605a - 605c. These three segments 605a - 605c are isolated from each other by two ceiling-mounted boundaries 625a and 625b extending from the ceiling 630 on the inside top wall of the housing 602. Suitably, seals 635a and 635b are located where the ceiling-mounted boundaries 625a and 625b join the jet plate 605 to prevent coolant fluid from one segment to flow directly into another segment without flowing through the jet plate or couch passages (shown best in FIGs. 7 and 12, discussed in more detail below) formed by the shapes, arrangements and relative positions of the jet plate 605, base plate 610, ceiling 630 and ceiling-mounted boundaries 625a and 625b. Effluent collection passages 640 ensure that coolant fluid that has already passed through micro-jet nozzle arrays in the jet plate segments 605a, 605b and 605c get funneled into the couch passages and/or outlet of the cooling module 600.

FIG. 7 shows the same cooling module 600 illustrated in FIG. 6 (Example A), but with housing 602 removed to show and identify the couch passages 705a and 705b fluidly connected to impingement volumes below each one of the micro-jet nozzle arrays 715a, 715b and 715c of each one of the three jet plate segments and the inlet plenums associated with the micro-jet nozzle arrays in downstream jet plate segments. For this example, there are two couch passages on each side (side A and side B) of each one of the micro-jet arrays in the jet plate segments of the cooling module. As shown in FIG. 7, two couch passages 705a (side A and side B) are configured to capture and guide coolant fluid (not shown in FIG. 7) that has undergone a first impingement by operation of the first micro-jet nozzle array 715a in a first segment of the jet plate. Two couch passages 705b (side A and side B) are configured to capture and guide coolant fluid that has undergone a second impingement by operation of the second micro-jet nozzle array 715b in a second segment of the jet plate. And two effluent channels 740 (side A and side B) capture and guide coolant fluid that has undergone a third impingement by operation of the third micro-jet nozzle array 715c in a third segment of the jet plate.

Couch passages 705a guide coolant fluid from an impingement volume (not shown in FIG. 7, but shown in FIG. 2) located below micro-jet nozzle array 715a into an inlet plenum (also not shown in FIG. 7, but illustrated in FIG. 2) located above micro-jet nozzle array 715b. Couch passages 705b route coolant fluid from an impingement volume located below micro-jet nozzle array 715b to an inlet plenum located above micro-jet nozzle array 715c. And effluent collection channels 740 are configured to route coolant fluid from an impingement volume located below micro-jet nozzle array 715c toward an outlet in the cooling module 700.

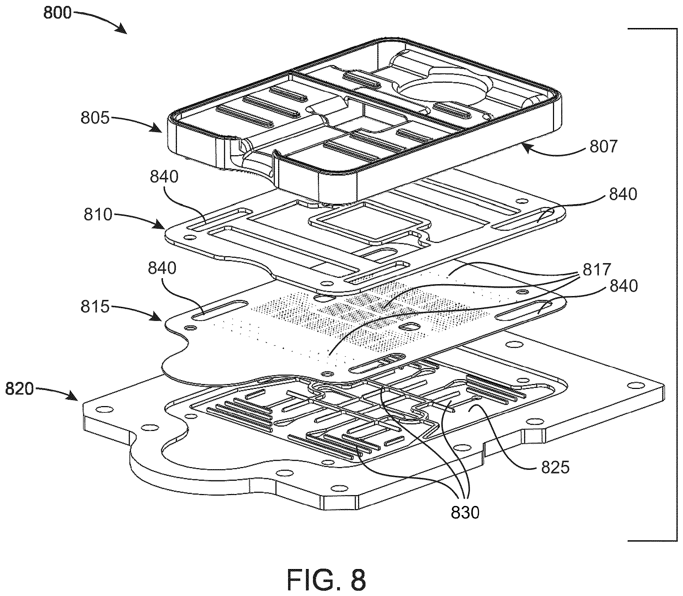

FIG. 8 shows an exploded view of another example (Example B) of a cooling module 800 constructed according to another embodiment of the present invention, with the housing removed in order to better illustrate some of the internal components. In this embodiment, an interstitial plate 805 and a sealing gasket 810 are inserted between the jet plate 815 and the housing (not shown). The jet plate 815 is segmented into three segments, each segment containing an array of micro-jet nozzles 817. After the coolant fluid has passed through the first and second micro-jet nozzle arrays to impinge on the cooling surface 825 of the base plate 820, the coolant fluid will be located in impingement volumes existing below the plane of the segmented jet plate 815. The couch passages (shown best in FIGs. 7 and 12) are used to move the coolant fluid out of the impingement volumes that lie below the plane of the segmented jet plate 815 and into the inlet plenums that lie above the plane of the segmented jet plate 815. Therefore, it is necessary that the couch passages be configured to "elevate" the coolant fluid from a level below the plane of the segmented jet plate 815 to a level located above the plane of the segmented jet plate 815 as it moves the coolant fluid from an impingement volume to a downstream inlet plenum. So at least some parts of the couch passages will exist below the plane of the segmented jet plate 815, while other parts of the couch passages will exist above the plane of the segmented jet plate 815.

The creation of the couch passages in the cooling module 800 may be facilitated by the insertion and use of the interstitial plate 805, which includes a ceiling 807 on the underside of the interstitial plate 805, the ceiling 807 having downward-extending ceiling-mounted boundaries (and/or walls or standoffs). These ceiling-mounted boundaries, in combination with the structures of the upper face of the segmented jet plate 815 and the ceiling 807 are conveniently used to form the parts of the couch passages existing above the plane of the segmented jet plate 815. In some embodiments, the ceiling 807 is an integral part of the interstitial plate 805. When there is no interstitial plate used, the features of the ceiling 807 may be formed on the inside top wall of the housing. In still other embodiments, the ceiling 807 may comprise a separately manufactured piece that may be inserted below the interstitial plate 805 or the inside top wall of the housing. The base plate 820 includes a cooling surface 825 that has upward-extending cooling surface-mounted boundaries 830 that are suitably shaped and arranged to cooperate with the structures of the lower face of the segmented jet plate 815 and the cooling surface 825 to form the parts of the couch passages existing below the plane of the segmented jet plate 815.

The sealing gasket 810 prevents the cooling fluid in one segment of the segmented jet plate 815 from flowing directly into a different segment of the segmented jet plate 815 without passing through the couch passages. Cutouts 840 in the segmented jet plate 815 and the corresponding parts of the sealing gasket 810 are part of the couch passages that allow coolant to pass through the plane of the segmented jet plate 815 while it is elevating the coolant fluid from the level below the plane of the segmented jet plate 815 to the level above the plane of the segmented jet plate 815.

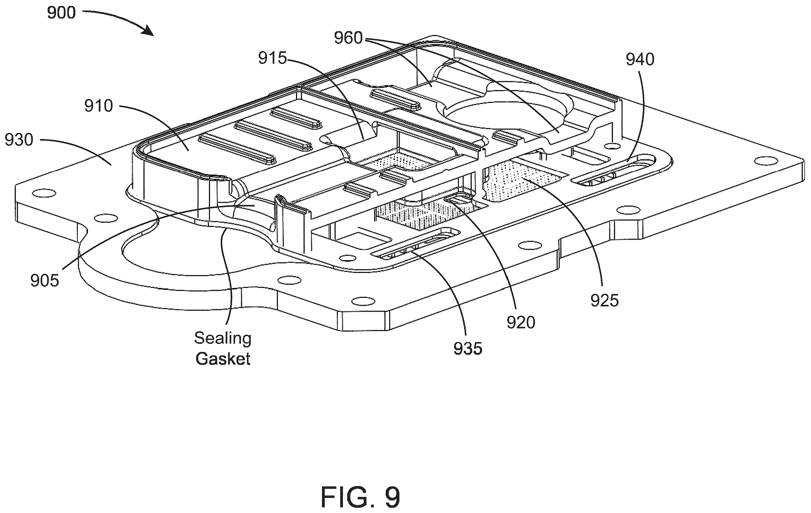

FIG. 9 shows a partial section view of the cooling module 900 (Example B) shown in the exploded view of FIG. 8. In this case, an inlet flow channel 905 cut into the top of the interstitial plate 910 routes cooling fluid from an inlet port on the housing (not shown) to roughly the center 915 of the cooling module 900. A first couch passage, which routes the coolant fluid back towards the inlet side of the segmented jet plate 920 prior to it flowing through the nozzle array in the second segment of the jet plate 925, is formed by the combination of structures associated with boundaries in the base plate 930, the segmented jet plate 925, and the interstitial plate 910. A second couch passage 935, which routes coolant fluid from the second segment of the segmented jet plate 925 to a third segment is also formed by boundaries in the base plate 930, the jet plate 925, and the interstitial plate 910, where it impinges in the third section before being collected in an effluent collection passage 940 within the interstitial plate 910 and then allowed to flow to an outlet port (not shown) via a couple of external flow channels 950 located between the bottom side of the top wall of the housing and the top side of the interstitial plate 910.

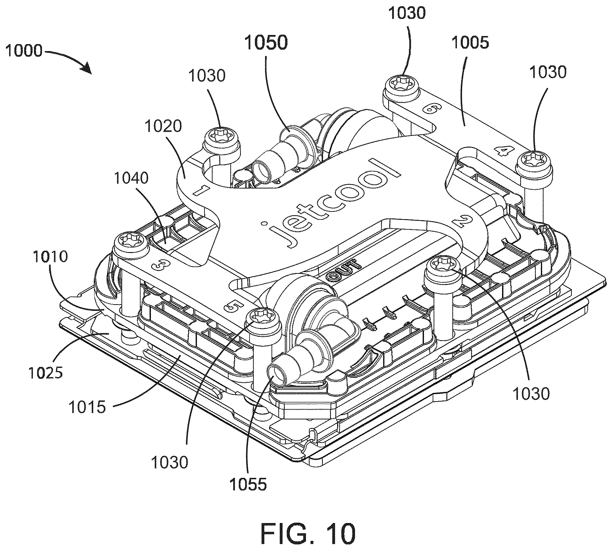

FIG. 10 shows a cooling module assembly 1000 (Example C) that uses a cooling module 1005 with internal recirculation constructed according to an embodiment of the present invention. In this example, the base plate 1010 of the cooling module 1005 is attached and secured to the surface to be cooled 1015 (a processor in this case) using a fastening system, which in this case comprises a tensioner plate 1020 that transmits compressive force from the processor mounting bracket 1025 (a bolster plate in this case) and the fasteners 1030 to the cooling module housing 1040. An inlet port 1050 attached to the housing 1040 is configured to admit pressurized coolant fluid produced by an external source into the cooling module 1005, and an outlet port 1055 attached to the housing 1040 is configured to discharge coolant fluid from the cooling module 1005. The base plate of the cooling module 1010 is in thermal communication with the surface to be cooled 1015 using a thermal interface material (not shown).

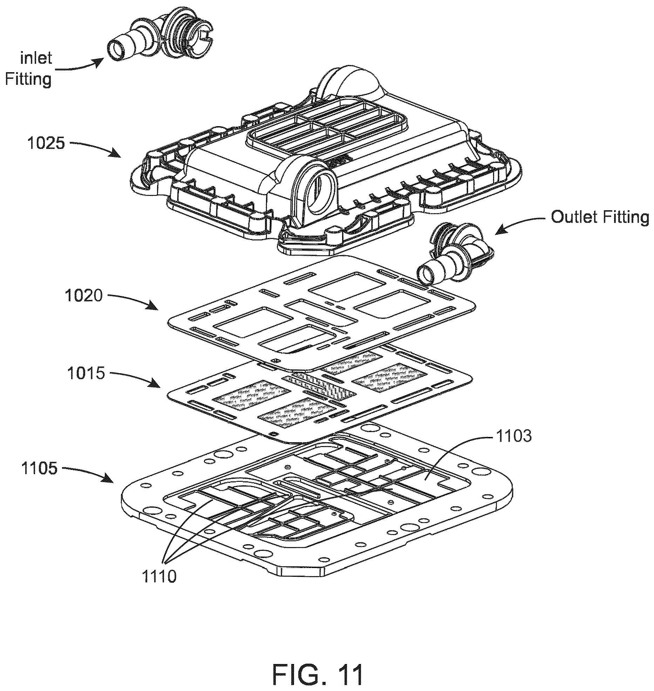

FIG. 11 shows an exploded view of the cooling module assembly shown in FIG. 10. The cooling surface 1103 of the base plate 1105 contains a number of cooling surface-mounted boundaries 1110 (walls or standoffs or channeling features) that, together with structures and cutouts built into the jet plate 1015, the sealing gasket 1020 and the housing 1025, help form the appropriately configured couch passages for moving cooling fluid from one segment of the jet plate 1015 to the next segment.

FIG. 12 shows a partial top view of the exemplary cooling module assembly shown in FIG. 10.. For ease of understanding, the housing, inlet port and outlet port have been removed from the image in the figure. As FIG. 12 shows, the inlet flow of coolant fluid is divided between two parallel sections of jet plate (Section 1A and Section 1B), each section containing a micro-jet nozzle array comprising a plurality of micro-jet nozzles. The discharge from these parallel sections is collected together through a number of couch passages to bring the coolant to Section 2. The couch passages of Section 2, route the flow to the top volume of fluid connected to the inlet plenum in Section 3. Section 3 in turn has couch passages connecting it to the fourth and final segment. Example C shows the ability to have parallel sections (1A and 1B) to be combined to lead to further serial sections (2, 3, 4). FIG. 12 also shows that the sections can be used to target specific areas of a processor chip to customize the heat transfer in each area.

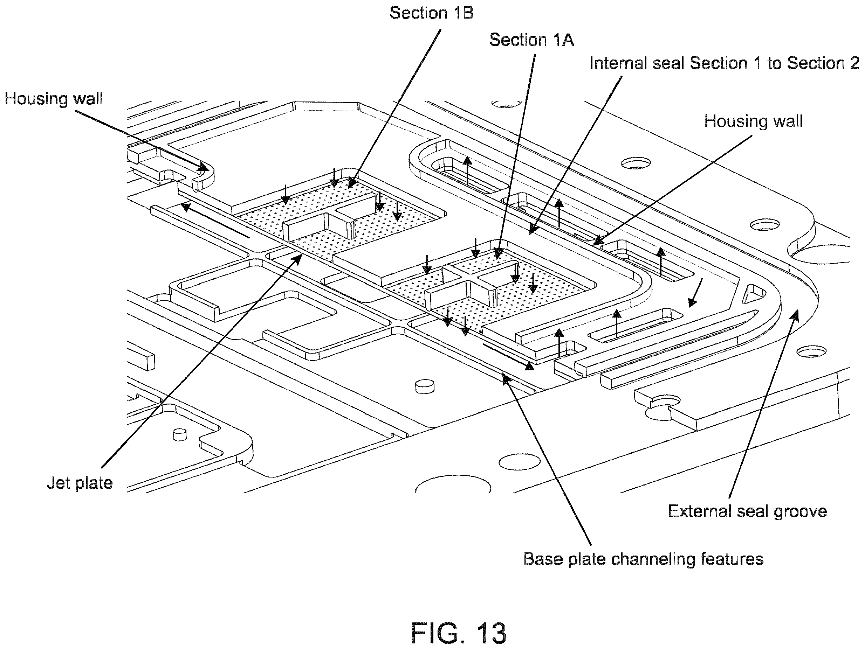

FIG. 13 further clarifies the flow path in the exemplary cooling module shown in FIGs. 10 - 12 by focusing on the couch passage formation from Sections 1A and 1B leading to Section 2. Notably, base plate channeling features, typically formed from copper, may be used to help form the couch passages. These positive features (sticking up from the copper) on the base plate, could also be achieved using a separate piece. The arrows in FIG. 13 illustrate the flow path taken by the coolant fluid traveling in the couch passage that connects the impingement volume of Section 1 to the inlet plenum of Section 2.

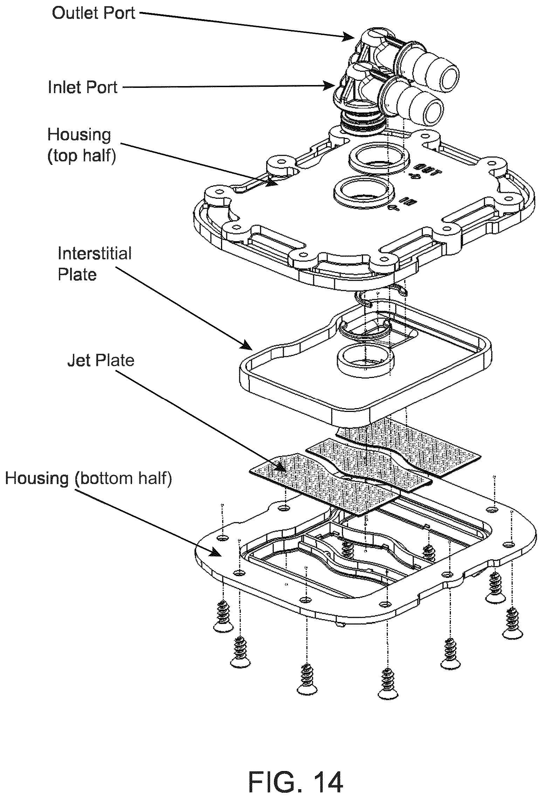

FIG. 14 shows an exploded view of another cooling module (Example D) constructed in accordance with an embodiment of the present invention. The cooling module shown mounts directly to the heat source and is therefore considered to be a direct cooling module. In this case, the internal passages do not have gaskets. The jet plate comprises three separate sections manufactured as three separate physical pieces, in this instance.

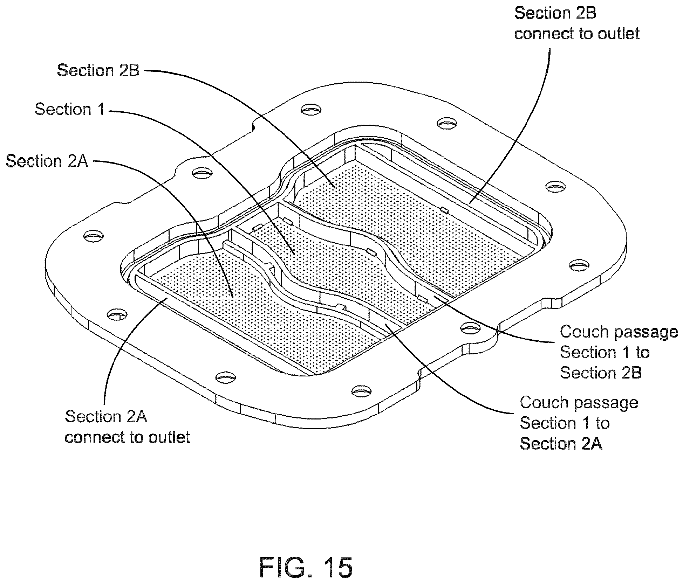

FIG. 15 shows the flow arrangement for the direct contact cooling module (Example D) shown in FIG. 14, and demonstrates how a single jet plate section connected to the inlet may be split into two parallel sections (Section 2A and Section 2B) before gathering the effluent from these sections together and transmitting the effluent to the outlet (not shown).

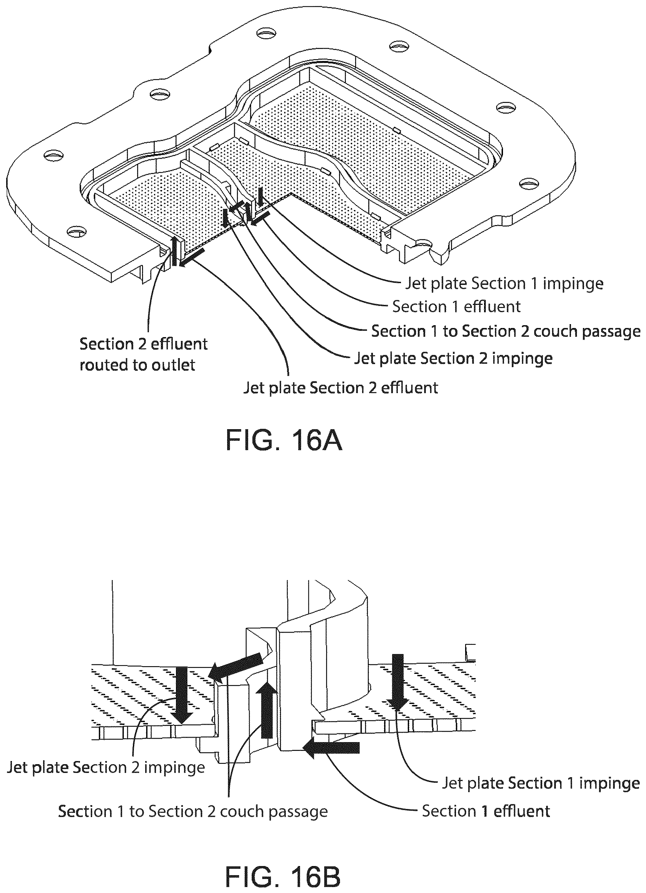

FIGs. 16A and 16B show partial sectional views of the direct contact cooling module (Example D) shown in FIG. 14. This sectional view illustrates in more detail the flow path from Section 1 to Section 2A. The couch passage in this case is formed by the jet plate, the lower half of the housing and the surface being cooled. FIG. 16 has an inset figure offering a close up of the flow path from Section 1 to Section 2A, through the couch passage.

The above-described preferred embodiments are intended to illustrate the principles of the invention, but not to limit its scope. Various other embodiments, modifications and equivalents to these preferred embodiments may occur to those skilled in the art upon reading the present disclosure or practicing the claimed invention, wherein the scope of the present application is defined by the appended claims.

## Claims

1. A cooling module (200; 600; 800; 900; 1005), comprising:
(a) a jet plate (210a-210d; 605; 815; 925; 1015) comprising an upper face, a lower face, a first segment (210a; 605a) that includes a first array of microjet nozzles (715a; 817) extending through the jet plate from the upper face of the jet plate to the lower face of the jet plate, and a second segment (210b; 605b) that includes a second array (715b; 817) of microjet nozzles extending through the jet plate from the upper face of the jet plate to the lower face of the jet plate, and
(b) a housing (206; 602;1040; 1025);
(c) a ceiling (216; 630; 807) disposed between the jet plate and the housing, the ceiling comprising a first ceiling-mounted boundary (218a; 625a) extending from the ceiling to the upper face of the jet plate and a second ceiling-mounted boundary (218b; 625b) extending from the ceiling to the upper face of the jet plate,
(d) a base plate (212; 610; 820; 930; 1010; 1105) comprising a cooling surface (212; 825; 1015; 1103), a first cooling surface-mounted boundary (220a; 830; 1110) extending from the cooling surface to the lower face of the jet plate, and a second cooling surface-mounted boundary (220b; 830; 1110) extending from the cooling surface to the lower face of the jet plate;
(e) wherein the jet plate (210a-210d; 605; 815; 925; 1015), the ceiling (216; 630; 807), the cooling surface (212; 825; 1015; 1103) of the base plate (212; 610; 820; 930; 1010; 1105), the first ceiling-mounted boundary (218a; 625a), the second ceiling-mounted boundary (218b; 625b), the first cooling surface-mounted boundary (220a; 830; 1110) and the second cooling surface-mounted boundary (220b; 830; 1110) are all arranged to define a first inlet plenum (222a) located between the ceiling and the first array of microjet nozzles (715a; 817), a second inlet plenum (222b) located between the ceiling and the second array of microjet nozzles (715b; 817), a first impingement volume (224a) located between the first array of microjet nozzles and the cooling surface, a second impingement volume (224b) located between the second array of microjet nozzles and the cooling surface, and a first couch passage (214a; 705a, 705b; 840) fluidly connecting the first impingement volume to the second inlet plenum;
(f) a fastening system (1020, 1025, 1030) for attaching the cooling module to a circuit board having one or more heat-generating electronic components affixed thereto so that the cooling surface of the base plate will be in thermal communication with said one or more heat-generating electronic components on the circuit board and absorbs heat generated by said one or more heat-generating electronic components while the circuit board is in operation; and
(g) an inlet fitting (202; 615; 1050) attached to the housing and configured to admit into the cooling module a pressurized coolant fluid transferred from an external source; and
(h) an inlet flow channel (905) to carry the pressurized liquid coolant fluid from the inlet fitting to the first inlet plenum;
(i) wherein,
(i) the first array of microjet nozzles in the first segment of the jet plate (715a; 817) is configured to receive the pressurized coolant fluid from the first inlet plenum (222a), accelerate the pressurized coolant fluid and direct the accelerated and pressurized coolant fluid to flow into the first impingement volume (224a) at high velocity to strike a first portion of the cooling surface of the base plate (212; 825; 1015; 1103), thereby removing the heat that the first portion of the cooling surface has absorbed from said one or more heat-generating electronic components,
(ii) the first couch passage (214a; 705a, 705b; 840) is configured to carry some of the pressurized coolant fluid out of the first impingement volume (224a) and into the second inlet plenum (222b), and
(iii) the second array of microjet nozzles in the jet plate (715b; 817) is configured to receive the pressurized coolant fluid from the second inlet plenum (222b), accelerate the pressurized coolant fluid and direct the accelerated and pressurized coolant fluid to flow into the second impingement volume (224b) at high velocity to strike a second portion of the cooling surface of the base plate (212; 825; 1015; 1103), thereby removing the heat that the second portion of the cooling surface has absorbed from said one or more heat-generating electronic components.

2. The cooling module of claim 1, further comprising:
(a) an outlet fitting (208; 620; 1055) connected to the housing (206; 602; 1040; 1025) and configured to discharge pressurized coolant fluid from the cooling module;
(b) a first effluent collection passage (640) configured to capture some of the pressurized coolant fluid from the first impingement volume (224a) and route the captured pressurized coolant fluid to the outlet fitting (208; 620; 1055) for discharge from the cooling module.

3. The cooling module of claim 2, further comprising a second effluent collection passage (640) configured to capture some of the pressurized coolant fluid from the second impingement volume (224b) and route the captured pressurized coolant fluid to the outlet fitting (208; 620; 1055) for discharge from the cooling module.

4. The cooling module of claim 1, wherein the ceiling (216; 630; 807) is manufactured as an integral component of the housing (206; 602; 1040; 1025).

5. The cooling module of claim 1, wherein the ceiling (216; 630; 807) is not manufactured as an integral component of the housing (206; 602; 1040; 1025).

6. The cooling module of claim 5, further comprising:
(a) an interstitial plate (805; 910) disposed between the housing (206; 602; 1040; 1025) and the jet plate (210a-210d; 605; 815; 925; 1015);
(b) wherein the ceiling (216; 630; 807) is manufactured as an integral component of the interstitial plate.

7. The cooling module of claim 1, further comprising a sealing gasket (635a; 810; 1020) that prevents pressurized coolant fluid entering the first segment of the jet plate (210a; 605a; 715a) from passing directly into the second segment of the jet plate (210b; 605b; 715b) without flowing through the first couch passage (214a; 705a; 705b; 840).

8. The cooling module of claim 1, wherein:
(a) the second segment of the jet plate (210b; 605b) surrounds and encloses the first segment of the jet plate (210a; 605a);
(b) the second ceiling-mounted boundary of the ceiling (218b; 625b) surrounds and encloses the first ceiling-mounted boundary (218a; 625a); and
(c) the second cooling surface-mounted boundary of the base plate (220b; 830; 1110) surrounds and encloses the first cooling surface-mounted boundary (220a; 830; 1110).

9. The cooling module of claim 1, wherein:
(a) the jet plate (210a-210d; 605; 815; 925; 1015) further comprises a third segment (210c; 605c; 715c) that includes a third array of microjet nozzles (715c; 817) extending through the jet plate from the upper face of the jet plate to the lower face of the jet plate;
(b) the ceiling (216; 630; 807) further comprises a third ceiling-mounted boundary (218c) extending from the ceiling to the upper face of the jet plate; and
(c) the base plate (212; 610; 820; 930; 1010; 1105) further comprises a third cooling surface-mounted boundary (220c; 830; 1110) extending from the cooling surface (212; 825; 1015; 1103) to the lower face of the jet plate;
(d) wherein the jet plate (210a-210d; 605; 815; 925; 1015), the ceiling (216; 630; 807), the cooling surface of the base plate (212; 825; 1015; 1103), the first ceiling-mounted boundary (218a; 625b), the second ceiling-mounted boundary (218b; 625b), the third ceiling mounted boundary (218c), the first cooling surface-mounted boundary (220a; 830; 1110), the second cooling surface-mounted boundary (220b; 830; 1110) and the third cooling surface-mounted boundary (220c; 830; 1110) are all arranged to define a third inlet plenum (222c) located between the ceiling and the third array of microjet nozzles (715c; 817), a third impingement volume (224c) located between the cooling surface and the third array of microjet nozzles, and a second couch passage (214b; 705a, 705b; 840; 935) fluidly connects either the first impingement volume (224a) or the second impingement volume (224b), or both, to the third inlet plenum; and
(e) the third array of microjet nozzles in the jet plate (715c, 817) is configured to receive the pressurized coolant fluid from the third inlet plenum (222c), accelerate the pressurized coolant fluid and direct the accelerated and pressurized coolant fluid to flow into the third impingement volume (224c) at high velocity to strike a third portion of the cooling surface of the base plate (212; 825; 1015; 1103), thereby removing the heat that the third portion of the cooling surface has absorbed from said one or more heat-generating electronic components.

10. The cooling module of claim 9, further comprising:
(a) an outlet fitting (208; 620; 1055) connected to the housing (206; 602; 1040; 1025) and configured to discharge pressurized coolant fluid from the cooling module;
(b) a first effluent collection passage (640; 740; 940) configured to capture some of the pressurized coolant fluid from the third impingement volume and route the captured pressurized coolant fluid to the outlet fitting for discharge from the cooling module (224c).

11. The cooling module of claim 9, further comprising a sealing gasket (635a; 810; 1020) that prevents pressurized coolant fluid entering the first segment of the jet plate (210a; 605a; 715a) from passing directly into the second segment of the jet plate (210b; 605b; 715b) without flowing through the first couch passage (214a; 705a, 705b; 840; 935).

12. The cooling module of claim 11, wherein the sealing gasket (635b; 810; 1020) prevents pressurized coolant fluid entering the second segment of the jet plate (210b; 605b; 715b) to flow directly into the third segment of the jet plate (210c; 605c; 715c) without flowing through the second couch passage (214b; 705a, 705b; 840; 935).

13. The cooling module of claim 9, wherein:
(a) the third segment of the jet plate (210c; 605c) surrounds and encloses the first segment (210a; 605a) of the jet plate and the second segment of the jet plate (210b; 605b);
(b) the third ceiling-mounted boundary of the ceiling (218c) surrounds and encloses the first ceiling-mounted boundary (218a; 635a) and the second ceiling-mounted boundary (218b; 635b); and
(c) the third cooling surface-mounted boundary (220c; 830; 1110) of the base plate surrounds and encloses the first cooling surface-mounted boundary (220b; 830; 1110) and the second cooling surface-mounted boundary (220b; 830; 1110).

14. The cooling module of claim 9, wherein the ceiling (216; 630; 807) is manufactured as an integral component of the housing (206; 602; 1040; 1025).

15. The cooling module of claim 9, wherein the ceiling (216; 630; 807) is not manufactured as an integral component of the housing (206; 602; 1040; 1025).

16. The cooling module of claim 15, further comprising:
(a) an interstitial plate (805; 910) disposed between the housing (206; 602; 1040; 1025) and the jet plate (210a-210d; 605; 815; 925; 1015);
(b) wherein the ceiling (216; 630; 807) is manufactured as an integral component of the interstitial plate.

17. The cooling module of claim 1, further comprising:
(a) a second jet plate comprising another upper face, another lower face and a third segment (210c; 605c) that includes a third array of microjet nozzles (715c; 817) extending through the second jet plate from said another upper face of the second jet plate to said another lower face of the second jet plate;
(b) wherein,
(i) the ceiling (216; 630; 807) further comprises a third ceiling-mounted boundary (218c) extending from the ceiling to said another upper face of the second jet plate, and
(ii) the base plate (212; 610; 820; 930; 1010; 1105) further comprises a third cooling surface-mounted boundary (220c; 830; 1110) extending from the cooling surface (212; 825; 1015; 1103) to said another lower face of the second jet plate,
(iii) wherein the second jet plate, the ceiling (216; 630; 807), the cooling surface of the base plate (212; 825; 1015; 1103), the first ceiling-mounted boundary (218a; 625a), the second ceiling-mounted boundary (218b; 625b), the third ceiling mounted boundary (218c), the first cooling surface-mounted boundary (220a; 830; 1110), the second cooling surface-mounted boundary (220b; 830; 1110) and the third cooling surface-mounted boundary (220c; 830; 1110) are all arranged to define a third inlet plenum (222c) located between the ceiling and the third array of microjet nozzles (715c; 817), a third impingement volume (224c) located between the cooling surface (212; 825; 1015; 1103) and the third array of microjet nozzles, and a second couch passage (214b; 705a; 705b; 840; 935) that fluidly connects the first impingement volume (224a) or the second impingement volume (224b), or both, to the third inlet plenum, and
(iv) the third array of microjet nozzles in the second jet plate (715c; 817) is configured to receive the pressurized coolant fluid from the third inlet plenum (222c), accelerate the pressurized coolant fluid and direct the accelerated and pressurized coolant fluid to flow into the third impingement volume (224c) at high velocity to strike a third portion of the cooling surface of the base plate (212; 610; 820; 930; 1010; 1105), thereby removing some of the heat that the third portion of the cooling surface has absorbed from said one or more heat-generating electronic components.

18. A method for cooling one or more heat-generating electronic components attached to a circuit board, the method comprising the steps of:
(a) providing a cooling module (200; 600; 800; 900; 1005) comprising a jet plate (210a-210d; 605; 815; 925; 1015), a housing (206; 602; 1040; 1025), a ceiling (216; 630; 807) disposed between the jet plate and the housing, a base plate (212; 610; 820; 930; 1010; 1105) having a cooling surface (212; 825; 1015; 1103), and a fastening system (1020, 1025, 1030) for fastening the cooling module to the circuit board;
(b) wherein (i) the jet plate (210a-210d; 605; 815; 925; 1015) comprises a first segment (210a; 605a; Section 1A, Section 1B) that includes a first array of microjet nozzles (715a, 817) extending through the jet plate, and a second segment (210b; 605b; Section 2) that includes a second array of microjet nozzles (715b; 817) extending through the jet plate, and (ii) the jet plate, the ceiling (216; 630; 807), the cooling surface of the base plate (212; 825; 1015; 1103), a first ceiling-mounted boundary (218a; 625a), a second ceiling-mounted boundary (218b; 625b), a first cooling surface-mounted boundary (220a; 830; 1110) and a second cooling surface-mounted boundary (220b; 830; 1110) are all arranged to define a first inlet plenum (222a) located between the ceiling and the first array of microjet nozzles, a second inlet plenum (222b) located between the ceiling and the second array of microjet nozzles, a first impingement volume (224a) located between the first array of microjet nozzles and the cooling surface (212; 825; 1015; 1103), a second impingement volume (224b) located between the second array of microjet nozzles and the cooling surface, and a first couch passage (214a; 705a 705b; 840) fluidly connecting the first impingement volume to the second inlet plenum;
(c) with the fastening system (1020, 1025, 1030), attaching the cooling module (200; 600; 800; 900; 1005) to the circuit board so that the cooling surface of the base plate (212; 825; 1015; 1103) will be in thermal communication with said one or more heat-generating electronic components on the circuit board and absorbs heat generated by said one or more heat-generating electronic components while the circuit board is in operation;
(d) connecting an external source for pressurized coolant fluid to an inlet port (202; 615; 1050) on the housing of the cooling module;
(e) transmitting pressurized coolant fluid received at the inlet port (202; 615; 1050) into the first inlet plenum of the jet plate (222a);
(f) with the first array of microjet nozzles (715a; 817) in the first segment of the jet plate (210a; 605a; Section 1A, Section 1B), receiving the pressurized cooling fluid from the first inlet plenum (222a), accelerating the pressurized coolant fluid and directing the accelerated and pressurized coolant fluid to flow into the first impingement volume (224a) at high velocity to strike a first portion of the cooling surface of the base plate (212; 825; 1015; 1103), thereby removing the heat that the first portion of the cooling surface has absorbed from said one or more heat-generating electronic components;
(g) with the first couch passage (214a; 705a, 705b; 840), transmitting some of the pressurized coolant fluid that struck the first portion of the cooling surface (212; 825; 1015; 1103) out of the first impingement volume (224a) into the second inlet plenum (222b); and
(h) with the second array of microjet nozzles in the jet plate (715b; 817), receiving the pressurized coolant fluid from the second inlet plenum (222b), accelerating the pressurized coolant fluid and directing the accelerated and pressurized coolant fluid to flow into the second impingement volume (224b) at high velocity to strike a second portion of the cooling surface of the base plate (212; 825; 1015; 1103) without permitting the pressurized coolant fluid to exit the cooling module (200; 600; 800; 900; 1005) before entering the second inlet plenum, thereby removing the heat that the second portion of the cooling surface has absorbed from said one or more heat-generating electronic components.

19. The method of claim 18, further comprising the steps of:
(a) capturing some of the pressurized coolant fluid in the first impingement volume (224a) that the first couch passage (214a; 705a, 705b; 840; 935) does not transmit to the second inlet plenum;
(b) routing the captured pressurized coolant fluid to an outlet fitting (208; 620; 1055) connected to the housing (206; 602; 1040; 1025); and
(c) discharging the pressurized cooling fluid from the cooling module (200; 600; 800; 900; 1005).

20. The method of claim 18, wherein the ceiling (216; 630; 807) is manufactured as an integral component of the housing (206; 602; 1040; 1025).

21. The method of claim 18, wherein the ceiling (216; 630; 807) is not manufactured as an integral component of the housing (206; 602; 1040; 1025).

## Patentansprüche

1. Kühlmodul (200; 600; 800; 900; 1005), umfassend:
(a) eine Strahlplatte (210a-210d; 605; 815; 925; 1015), umfassend eine obere Fläche, eine untere Fläche, ein erstes Segment (210a; 605a), das ein erstes Array von Mikrostrahldüsen (715a; 817) enthält, die sich von der oberen Fläche der Strahlplatte zur unteren Fläche der Strahlplatte durch die Strahlplatte erstrecken, und ein zweites Segment (210b; 605b), das ein zweites Array (715b; 817) von Mikrostrahldüsen, die sich von der oberen Fläche der Strahlplatte zur unteren Fläche der Strahlplatte durch die Strahlplatte erstrecken, und
(b) ein Gehäuse (206; 602; 1040; 1025);
(c) eine Decke (216; 630; 807), die zwischen der Strahlplatte und dem Gehäuse angeordnet ist, wobei die Decke eine erste deckenmontierte Begrenzung (218a; 625a), die sich von der Decke zur oberen Fläche der Strahlplatte erstreckt, und eine zweite deckenmontierte Begrenzung (218b; 625b), die sich von der Decke zur oberen Fläche der Strahlplatte erstreckt, umfasst,
(d) eine Grundplatte (212; 610; 820; 930; 1010; 1105), umfassend eine Kühlfläche (212; 825; 1015; 1103), eine erste an der Kühlfläche montierte Begrenzung (220a; 830; 1110), die sich von der Kühlfläche zur unteren Fläche der Strahlplatte erstreckt, und eine zweite an der Kühlfläche montierte Begrenzung (220b; 830; 1110), die sich von der Kühlfläche zur unteren Fläche der Strahlplatte erstreckt;
(e) wobei die Strahlplatte (210a-210d; 605; 815; 925; 1015), die Decke (216; 630; 807), die Kühlfläche (212; 825; 1015; 1103) der Grundplatte (212; 610; 820; 930; 1010; 1105), die erste deckenmontierte Begrenzung (218a; 625a), die zweite deckenmontierte Begrenzung (218b; 625b), die erste an der Kühlfläche montierte Begrenzung (220a; 830; 1110) und die zweite an der Kühlfläche montierte Begrenzung (220b; 830; 1110) alle dazu angeordnet sind, eine erste Einlasskammer (222a), die sich zwischen der Decke und dem ersten Array von Mikrostrahldüsen (715a; 817) befindet, eine zweite Einlasskammer (222b), die sich zwischen dem Array von Mikrostrahldüsen (715b; 817) befindet, ein erstes Aufprallvolumen (224a), das sich zwischen dem ersten Array von Mikrostrahldüsen und der Kühlfläche befindet, ein zweites Aufprallvolumen (224b), das sich zwischen dem zweiten Array von Mikrostrahldüsen und der Kühlfläche befindet, und einen ersten Auffangdurchgang (214a; 705a, 705b; 840), der das erste Aufprallvolumen mit der zweiten Einlasskammer fluidverbindet, zu definieren;
(f) ein Befestigungssystem (1020, 1025, 1030) zum Anbringen des Kühlmoduls an einer Leiterplatte, an der eine oder mehrere wärmeerzeugende elektronische Komponenten fixiert sind, sodass die Kühlfläche der Grundplatte in thermischer Kommunikation mit der einen oder den mehreren wärmeerzeugenden elektronischen Komponenten auf der Leiterplatte steht und Wärme absorbiert, die durch die eine oder die mehreren wärmeerzeugenden elektronischen Komponenten erzeugt wird, während die Leiterplatte in Betrieb ist; und
(g) eine Einlassarmatur (202; 615; 1050), die am Gehäuse angebracht und dazu ausgelegt ist, ein unter Druck stehendes Kühlmittelfluid, das von einer externen Quelle übertragen wird, in das Kühlmodul einzulassen; und
(h) einen Einlassströmungskanal (905), um das unter Druck stehende flüssige Kühlmittelfluid von der Einlassarmatur zur ersten Einlasskammer zu leiten;
(i) wobei
(i) das erste Array von Mikrostrahldüsen im ersten Segment der Strahlplatte (715a; 817) dazu ausgelegt ist, das unter Druck stehende Kühlmittelfluid von der ersten Einlasskammer (222a) aufzunehmen, das unter Druck stehende Kühlmittelfluid zu beschleunigen und das beschleunigte und unter Druck stehende Kühlmittelfluid zu leiten, mit hoher Geschwindigkeit in das erste Aufprallvolumen (224a) zu strömen, um auf einen ersten Abschnitt der Kühlfläche der Grundplatte (212; 825; 1015; 1103) zu treffen, wodurch die Wärme, die der erste Abschnitt der Kühlfläche von der einen oder den mehreren wärmeerzeugenden elektronischen Komponenten absorbiert hat, abgeleitet wird,
(ii) der erste Auffangdurchgang (214a; 705a, 705b; 840) dazu ausgelegt ist, einen Teil des unter Druck stehenden Kühlmittelfluids aus dem ersten Aufprallvolumen (224a) und in die zweite Einlasskammer (222b) zu leiten, und
(iii) das zweite Array von Mikrostrahldüsen in der Strahlplatte (715b; 817) dazu ausgelegt ist, das unter Druck stehende Kühlmittelfluid von der zweiten Einlasskammer (222b) aufzunehmen, das unter Druck stehende Kühlmittelfluid zu beschleunigen und das beschleunigte und unter Druck stehende Kühlmittelfluid zu leiten, mit hoher Geschwindigkeit in das zweite Aufprallvolumen (224b) zu strömen, um auf einen zweiten Abschnitt der Kühlfläche der Grundplatte (212; 825; 1015; 1103) zu treffen, wodurch die Wärme, die der zweite Abschnitt der Kühlfläche von der einen oder den mehreren wärmeerzeugenden elektronischen Komponenten absorbiert hat, abgeleitet wird.

2. Kühlmodul nach Anspruch 1, ferner Folgendes umfassend:
(a) eine Auslassarmatur (208; 620; 1055), die mit dem Gehäuse (206; 602; 1040; 1025) verbunden und dazu ausgelegt ist, unter Druck stehendes Kühlmittelfluid aus dem Kühlmodul abzulassen;
(b) einen ersten Abflusssammeldurchgang (640), der dazu ausgelegt ist, einen Teil des unter Druck stehenden Kühlmittelfluids aus dem ersten Aufprallvolumen (224a) zu erfassen und das erfasste unter Druck stehende Kühlmittelfluid zum Ablassen aus dem Kühlmodul zur Auslassarmatur (208; 620; 1055) zu leiten.

3. Kühlmodul nach Anspruch 2, ferner umfassend einen zweiten Abflusssammeldurchgang (640), der dazu ausgelegt ist, einen Teil des unter Druck stehenden Kühlmittelfluids aus dem zweiten Aufprallvolumen (224b) zu erfassen und das erfasste unter Druck stehende Kühlmittelfluid zum Ablassen aus dem Kühlmodul zur Auslassarmatur (208; 620; 1055) zu leiten.

4. Kühlmodul nach Anspruch 1, wobei die Decke (216; 630; 807) als integrale Komponente des Gehäuses (206; 602; 1040; 1025) hergestellt ist.

5. Kühlmodul nach Anspruch 1, wobei die Decke (216; 630; 807) nicht als integrale Komponente des Gehäuses (206; 602; 1040; 1025) hergestellt ist.

6. Kühlmodul nach Anspruch 5, ferner Folgendes umfassend:
(a) eine Zwischenplatte (805; 910), die zwischen dem Gehäuse (206; 602; 1040; 1025) und der Strahlplatte (210a-210d; 605; 815; 925; 1015) angeordnet ist;
(b) wobei die Decke (216; 630; 807) als integrale Komponente der Zwischenplatte hergestellt ist.

7. Kühlmodul nach Anspruch 1, ferner umfassend eine Dichtung (635a; 810; 1020), die verhindert, dass unter Druck stehendes Kühlmittelfluid, das in das erste Segment der Strahlplatte (210a; 605a; 715a) eintritt, direkt in das zweite Segment der Strahlplatte (210b; 605b; 715b) strömt, ohne durch den ersten Auffangdurchgang (214a; 705a; 705b; 840) zu strömen.

8. Kühlmodul nach Anspruch 1, wobei:
(a) das zweite Segment der Strahlplatte (210b; 605b) das erste Segment der Strahlplatte (210a; 605a) umgibt und umschließt;
(b) die zweite deckenmontierte Begrenzung der Decke (218b; 625b) die erste deckenmontierte Begrenzung (218a; 625a) umgibt und umschließt und
(c) die zweite an der Kühlfläche montierte Begrenzung der Grundplatte (220b; 830; 1110) die erste an der Kühlfläche montierte Begrenzung (220a; 830; 1110) umgibt und umschließt.

9. Kühlmodul nach Anspruch 1, wobei:
(a) die Strahlplatte (210a-210d; 605; 815; 925; 1015) ferner ein drittes Segment (210c; 605c; 715c) umfasst, das ein drittes Array von Mikrostrahldüsen (715c; 817) enthält, die sich von der oberen Fläche der Strahlplatte zur unteren Fläche der Strahlplatte durch die Strahlplatte erstrecken;
(b) die Decke (216; 630; 807) ferner eine dritte deckenmontierte Begrenzung (218c) umfasst, die sich von der Decke zur oberen Fläche der Strahlplatte erstreckt; und
(c) die Grundplatte (212; 610; 820; 930; 1010; 1105) ferner eine dritte an der Kühlfläche montierte Begrenzung (220c; 830; 1110) umfasst, die sich von der Kühlfläche (212; 825; 1015; 1103) zur unteren Fläche der Strahlplatte erstreckt;
(d) wobei die Strahlplatte (210a-210d; 605; 815; 925; 1015), die Decke (216; 630; 807), die Kühlfläche der Grundplatte (212; 825; 1015; 1103), die erste deckenmontierte Begrenzung (218a; 625b), die zweite deckenmontierte Begrenzung (218b; 625b), die dritte deckenmontierte Begrenzung (218c), die erste an der Kühlfläche montierte Begrenzung (220a; 830; 1110), die zweite an der Kühlfläche montierte Begrenzung (220b; 830; 1110) und die dritte an der Kühlfläche montierte Begrenzung (220c; 830; 1110) alle dazu angeordnet sind, eine dritte Einlasskammer (222c), die sich zwischen der Decke und dem dritten Array von Mikrostrahldüsen (715c; 817) befindet, ein drittes Aufprallvolumen (224c), das sich zwischen der Kühlfläche und dem dritten Array von Mikrostrahldüsen befindet, und einen zweiten Auffangdurchgang (214b; 705a, 705b; 840; 935), der das erste Aufprallvolumen (224a) oder das zweite Aufprallvolumen (224b) oder beide mit der dritten Einlasskammer fluidverbindet, zu definieren; und
(e) das dritte Array von Mikrostrahldüsen in der Strahlplatte (715c, 817) dazu ausgelegt ist, das unter Druck stehende Kühlmittelfluid von der dritten Einlasskammer (222c) aufzunehmen, das unter Druck stehende Kühlmittelfluid zu beschleunigen und das beschleunigte und unter Druck stehende Kühlmittelfluid zu leiten, mit hoher Geschwindigkeit in das dritte Aufprallvolumen (224c) zu strömen, um auf einen dritten Abschnitt der Kühlfläche der Grundplatte (212; 825; 1015; 1103) zu treffen, wodurch die Wärme, die der dritte Abschnitt der Kühlfläche von der einen oder den mehreren wärmeerzeugenden elektronischen Komponenten absorbiert hat, abgeleitet wird.

10. Kühlmodul nach Anspruch 9, ferner Folgendes umfassend:
(a) eine Auslassarmatur (208; 620; 1055), die mit dem Gehäuse (206; 602; 1040; 1025) verbunden und dazu ausgelegt ist, unter Druck stehendes Kühlmittelfluid aus dem Kühlmodul abzulassen;
(b) einen ersten Abflusssammeldurchgang (640; 740; 940), der dazu ausgelegt ist, einen Teil des unter Druck stehenden Kühlmittelfluids aus dem dritten Aufprallvolumen zu erfassen und das erfasste unter Druck stehende Kühlmittelfluid zum Ablassen aus dem Kühlmodul (224c) zur Auslassarmatur zu leiten.

11. Kühlmodul nach Anspruch 9, ferner umfassend eine Dichtung (635a; 810; 1020), die verhindert, dass unter Druck stehendes Kühlmittelfluid, das in das erste Segment der Strahlplatte (210a; 605a; 715a) eintritt, direkt in das zweite Segment der Strahlplatte (210b; 605b; 715b) strömt, ohne durch den ersten Auffangdurchgang (214a; 705a, 705b; 840; 935) zu strömen.

12. Kühlmodul nach Anspruch 11, wobei die Dichtung (635b; 810; 1020) verhindert, dass unter Druck stehendes Kühlmittelfluid, das in das zweite Segment der Strahlplatte (210b; 605b; 715b) eintritt, direkt in das dritte Segment der Strahlplatte (210c; 605c; 715c) strömt, ohne durch den zweiten Auffangdurchgang (214b; 705a, 705b; 840; 935) zu strömen.

13. Kühlmodul nach Anspruch 9, wobei:
(a) das dritte Segment der Strahlplatte (210c; 605c) das erste Segment (210a; 605a) der Strahlplatte und das zweite Segment der Strahlplatte (210b; 605b) umgibt und umschließt;
(b) die dritte deckenmontierte Begrenzung der Decke (218c) die erste deckenmontierte Begrenzung (218a; 635a) und die zweite deckenmontierte Begrenzung (218b; 635b) umgibt und umschließt und
(c) die dritte an der Kühlfläche montierte Begrenzung (220c; 830; 1110) der Grundplatte die erste an der Kühlfläche montierte Begrenzung (220b; 830; 1110) und die zweite an der Kühlfläche montierte Begrenzung (220b; 830; 1110) umgibt und umschließt.

14. Kühlmodul nach Anspruch 9, wobei die Decke (216; 630; 807) als integrale Komponente des Gehäuses (206; 602; 1040; 1025) hergestellt ist.

15. Kühlmodul nach Anspruch 9, wobei die Decke (216; 630; 807) nicht als integrale Komponente des Gehäuses (206; 602; 1040; 1025) hergestellt ist.

16. Kühlmodul nach Anspruch 15, ferner Folgendes umfassend:
(a) eine Zwischenplatte (805; 910), die zwischen dem Gehäuse (206; 602; 1040; 1025) und der Strahlplatte (210a-210d; 605; 815; 925; 1015) angeordnet ist;
(b) wobei die Decke (216; 630; 807) als integrale Komponente der Zwischenplatte hergestellt ist.

17. Kühlmodul nach Anspruch 1, ferner Folgendes umfassend:
(a) eine zweite Strahlplatte, umfassend eine weitere obere Fläche, eine weitere untere Fläche und ein drittes Segment (210c; 605c), das ein drittes Array von Mikrostrahldüsen (715c; 817) enthält, die sich von der weiteren oberen Fläche der zweiten Strahlplatte zur weiteren unteren Fläche der zweiten Strahlplatte durch die zweite Strahlplatte erstrecken;
(b) wobei
(i) die Decke (216; 630; 807) ferner eine dritte deckenmontierte Begrenzung (218c) umfasst, die sich von der Decke zur weiteren oberen Fläche der zweiten Strahlplatte erstreckt, und
(ii) die Grundplatte (212; 610; 820; 930; 1010; 1105) ferner eine dritte an der Kühlfläche montierte Begrenzung (220c; 830; 1110) umfasst, die sich von der Kühlfläche (212; 825; 1015; 1103) zur weiteren unteren Fläche der zweiten Strahlplatte erstreckt,
(iii) wobei die zweite Strahlplatte, die Decke (216; 630; 807), die Kühlfläche der Grundplatte (212; 825; 1015; 1103), die erste deckenmontierte Begrenzung (218a; 625a), die zweite deckenmontierte Begrenzung (218b; 625b), die dritte deckenmontierte Begrenzung (218c), die erste kühlflächenmontierte Begrenzung (220a; 830; 1110), die zweite kühlflächenmontierte Begrenzung (220b; 830; 1110) und die dritte kühlflächenmontierte Begrenzung (220c; 830; 1110) alle dazu angeordnet sind, eine dritte Einlasskammer (222c), die sich zwischen der Decke und dem dritten Array von Mikrostrahldüsen (715c; 817) befindet, ein drittes Aufprallvolumen (224c), das sich zwischen der Kühlfläche (212; 825; 1015; 1103) und dem dritten Array von Mikrostrahldüsen befindet, und einen zweiten Auffangdurchgang (214b; 705a; 705b; 840; 935), der das erste Aufprallvolumen (224a) oder das zweite Aufprallvolumen (224b) oder beide mit der dritten Einlasskammer fluidverbindet, zu definieren; und
(iv) das dritte Array von Mikrostrahldüsen in der zweiten Strahlplatte (715c; 817) dazu ausgelegt ist, das unter Druck stehende Kühlmittelfluid von der dritten Einlasskammer (222c) aufzunehmen, das unter Druck stehende Kühlmittelfluid zu beschleunigen und das beschleunigte und unter Druck stehende Kühlmittelfluid zu leiten, mit hoher Geschwindigkeit in das dritte Aufprallvolumen (224c) zu strömen, um auf einen dritten Abschnitt der Kühlfläche der Grundplatte (212; 610; 820; 930; 1010; 1105) zu treffen, wodurch ein Teil der Wärme, die der dritte Abschnitt der Kühlfläche von der einen oder den mehreren wärmeerzeugenden elektronischen Komponenten absorbiert hat, abgeleitet wird.

18. Verfahren zum Kühlen einer oder mehrerer wärmeerzeugender elektronischer Komponenten, die an einer Leiterplatte angebracht sind, wobei das Verfahren die folgenden Schritte umfasst:
(a) Vorsehen eines Kühlmoduls (200; 600; 800; 900; 1005), umfassend eine Strahlplatte (210a-210d; 605; 815; 925; 1015), ein Gehäuse (206; 602; 1040; 1025), eine Decke (216; 630; 807), die zwischen der Strahlplatte und dem Gehäuse angeordnet ist, eine Grundplatte (212; 610; 820; 930; 1010; 1105) mit einer Kühlfläche (212; 825; 1015; 1103) und ein Befestigungssystem (1020, 1025, 1030) zum Anbringen des Kühlmoduls an einer Leiterplatte;
(b) wobei (i) die Strahlplatte (210a-210d; 605; 815; 925; 1015) ein erstes Segment (210a; 605a; Abschnitt 1A, Abschnitt 1B), das ein erstes Array von Mikrostrahldüsen (715a, 817), die sich durch die Strahlplatte erstrecken, und ein zweites Segment (210b; 605b; Abschnitt 2), das ein zweites Array von Mikrostrahldüsen (715b; 817), die sich durch die Strahlplatte erstrecken, umfasst und (ii) die Strahlplatte, die Decke (216; 630; 807), die Kühlfläche der Grundplatte (212; 825; 1015; 1103), eine erste deckenmontierte Begrenzung (218a; 625a), eine zweite deckenmontierte Begrenzung (218b; 625b), eine erste kühlflächenmontierte Begrenzung (220a; 830; 1110) und eine zweite kühlflächenmontierte Begrenzung (220b; 830; 1110) alle dazu angeordnet sind, eine erste Einlasskammer (222a), die sich zwischen der Decke und dem ersten Array von Mikrostrahldüsen befindet, eine zweite Einlasskammer (222b), die sich zwischen der Decke und dem zweiten Array von Mikrostrahldüsen befindet, ein erstes Aufprallvolumen (224a), das sich zwischen dem ersten Array von Mikrostrahldüsen und der Kühlfläche (212; 825; 1015; 1103) befindet, und ein zweites Aufprallvolumen (224b), das sich zwischen dem zweiten Array von Mikrostrahldüsen und der Kühlfläche befindet, und einen ersten Auffangdurchgang (214a; 705a 705b; 840), der das erste Aufprallvolumen mit der zweiten Einlasskammer fluidverbindet, zu definieren;
(c) Befestigen des Kühlmoduls (200; 600; 800; 900; 1005) mit dem Befestigungssystem (1020, 1025, 1030) an der Leiterplatte, sodass die Kühlfläche der Grundplatte (212; 825; 1015; 1103) in thermischer Kommunikation mit der einen oder den mehreren wärmeerzeugenden elektronischen Komponenten auf der Leiterplatte steht und Wärme absorbiert, die durch die eine oder die mehreren wärmeerzeugenden elektronischen Komponenten erzeugt wird, während die Leiterplatte in Betrieb ist;
(d) Verbinden einer externen Quelle für unter Druck stehendes Kühlmittelfluid mit einem Einlassanschluss (202; 615; 1050) am Gehäuse des Kühlmoduls;
(e) Übertragen von unter Druck stehendem Kühlmittelfluid, das am Einlassanschluss (202; 615; 1050) aufgenommen wird, in die erste Einlasskammer der Strahlplatte (222a);
(f) mit dem ersten Array von Mikrostrahldüsen (715a; 817) im ersten Segment der Strahlplatte (210a; 605a; Abschnitt 1A, Abschnitt 1B), Aufnehmen des unter Druck stehenden Kühlfluids von der ersten Einlasskammer (222a), Beschleunigen des unter Druck stehenden Kühlmittelfluids und Leiten des beschleunigten und unter Druck stehenden Kühlmittelfluids, mit hoher Geschwindigkeit in das erste Aufprallvolumen (224a) zu strömen, um auf einen ersten Abschnitt der Kühlfläche der Grundplatte (212; 825; 1015; 1103) zu treffen, wodurch die Wärme, die der erste Abschnitt der Kühlfläche von der einen oder den mehreren wärmeerzeugenden elektronischen Komponenten absorbiert hat, abgeleitet wird;
(g) mit dem ersten Auffangdurchgang (214a; 705a, 705b; 840) Übertragen eines Teils des unter Druck stehenden Kühlmittelfluids, das auf den ersten Teil der Kühlfläche (212; 825; 1015; 1103) aufgetroffen ist, aus dem ersten Auftreffvolumen (224a) in die zweite Einlasskammer (222b) und
(h) mit dem zweiten Array von Mikrostrahldüsen in der Strahlplatte (715b; 817) Aufnehmen des unter Druck stehenden Kühlmittelfluids von der zweiten Einlasskammer (222b), Beschleunigen des unter Druck stehenden Kühlmittelfluids und Leiten des beschleunigten und unter Druck stehenden Kühlmittelfluids, mit hoher Geschwindigkeit in das zweite Aufprallvolumen (224b) zu strömen, um auf einen zweiten Abschnitt der Kühlfläche der Grundplatte (212; 825; 1015; 1103) zu treffen, ohne zuzulassen, dass das unter Druck stehende Kühlmittelfluid aus dem Kühlmodul (200; 600; 800; 900; 1005) austritt, bevor es in die zweite Einlasskammer eintritt, wodurch die Wärme, die der zweite Abschnitt der Kühlfläche von der einen oder den mehreren wärmeerzeugenden elektronischen Komponenten absorbiert hat, abgeleitet wird.

19. Verfahren nach Anspruch 18, ferner die folgenden Schritte umfassend:
(a) Auffangen eines Teils des unter Druck stehenden Kühlmittelfluids im ersten Aufprallvolumen (224a), das der erste Auffangdurchgang (214a; 705a, 705b; 840; 935) nicht zur zweiten Einlasskammer überträgt;
(b) Leiten des aufgefangenen unter Druck stehenden Kühlmittelfluids zu einer Auslassarmatur (208; 620; 1055), die mit dem Gehäuse (206; 602; 1040; 1025) verbunden ist; und
(c) Ablassen des unter Druck stehenden Kühlfluids aus dem Kühlmodul (200; 600; 800; 900; 1005).

20. Verfahren nach Anspruch 18, wobei die Decke (216; 630; 807) als integrale Komponente des Gehäuses (206; 602; 1040; 1025) hergestellt ist.

21. Verfahren nach Anspruch 18, wobei die Decke (216; 630; 807) nicht als integrale Komponente des Gehäuses (206; 602; 1040; 1025) hergestellt ist.

## Revendications

1. Module de refroidissement (200 ; 600 ; 800 ; 900 ; 1005), comprenant :
(a) une plaque à jet (210a-210d ; 605 ; 815 ; 925 ; 1015) comprenant une face supérieure, une face inférieure, un premier segment (210a ; 605a) qui inclut un premier réseau de buses à microjet (715a ; 817) s'étendant à travers la plaque à jet depuis la face supérieure de la plaque à jet jusqu'à la face inférieure de la plaque à jet, et un deuxième segment (210b ; 605b) qui inclut un deuxième réseau (715b ; 817) de buses à microjet s'étendant à travers la plaque à jet depuis la face supérieure de la plaque à jet jusqu'à la face inférieure de la plaque à jet, et
(b) un boîtier (206 ; 602 ; 1040 ; 1025) ;
(c) un plafond (216 ; 630 ; 807) disposé entre la plaque à jet et le boîtier, le plafond comprenant une première limite montée sur plafond (218a ; 625a) s'étendant depuis le plafond jusqu'à la face supérieure de la plaque à jet et une deuxième limite montée sur plafond (218b ; 625b) s'étendant depuis le plafond jusqu'à la face supérieure de la plaque à jet,
(d) une plaque de base (212 ; 610 ; 820 ; 930 ; 1010 ; 1105) comprenant une surface de refroidissement (212 ; 825 ; 1015 ; 1103), une première limite montée sur surface de refroidissement (220a ; 830 ; 1110) s'étendant depuis la surface de refroidissement jusqu'à la face inférieure de la plaque à jet, et une deuxième limite montée sur surface de refroidissement (220b ; 830 ; 1110) s'étendant depuis la surface de refroidissement jusqu'à la face inférieure de la plaque à jet ;
(e) dans lequel la plaque à jet (210a-210d ; 605 ; 815 ; 925 ; 1015), le plafond (216 ; 630 ; 807), la surface de refroidissement (212 ; 825 ; 1015 ; 1103) de la plaque de base (212 ; 610 ; 820 ; 930 ; 1010 ; 1105), la première limite montée sur plafond (218a ; 625a), la deuxième limite montée sur plafond (218b ; 625b), la première limite montée sur surface de refroidissement (220a ; 830 ; 1110), et la deuxième limite montée sur surface de refroidissement (220b ; 830 ; 1110) sont tous agencés pour définir une première chambre d'entrée (222a) située entre le plafond et le premier réseau de buses à microjet (715a ; 817), une deuxième chambre d'entrée (222b) située entre le plafond et le deuxième réseau de buses à microjet (715b ; 817), un premier volume d'impact (224a) situé entre le premier réseau de buses à microjet et la surface de refroidissement, un second volume d'impact (224b) situé entre le deuxième réseau de buses à microjet et la surface de refroidissement, et un premier passage de transmission (214a ; 705a, 705b ; 840) reliant fluidiquement le premier volume d'impact à la deuxième chambre d'entrée ;
(f) un système de fixation (1020, 1025, 1030) pour attacher le module de refroidissement à une carte de circuit imprimé ayant un ou plusieurs composants électroniques générateurs de chaleur apposés à celle-ci de telle sorte que la surface de refroidissement de la plaque de base soit en communication thermique avec ledit un ou lesdits plusieurs composants électroniques générateurs de chaleur sur la carte de circuit imprimé et absorbe de la chaleur générée par ledit un ou lesdits plusieurs composants électroniques générateurs de chaleur alors que la carte de circuit imprimé est en fonctionnement ; et
(g) un raccord d'entrée (202 ; 615 ; 1050) attaché au boîtier et configuré pour admettre, dans le module de refroidissement, un fluide de refroidissement mis sous pression transféré depuis une source externe ; et
(h) un canal d'écoulement d'entrée (905) pour transporter le fluide de refroidissement liquide mis sous pression depuis le raccord d'entrée jusqu'à la première chambre d'entrée ;
(i) dans lequel
(i) le premier réseau de buses à microjet dans le premier segment de la plaque à jet (715a ; 817) est configuré pour recevoir le fluide de refroidissement mis sous pression en provenance de la première chambre d'entrée (222a), accélérer le fluide de refroidissement mis sous pression, et diriger le fluide de refroidissement accéléré et mis sous pression pour qu'il s'écoule dans le premier volume d'impact (224a) à haute vitesse pour frapper une première portion de la surface de refroidissement de la plaque de base (212 ; 825 ; 1015 ; 1103), éliminant ainsi la chaleur que la première portion de la surface de refroidissement a absorbé depuis ledit un ou lesdits plusieurs composants électroniques générateurs de chaleur,
(ii) le premier passage de transmission (214a ; 705a, 705b ; 840) est configuré pour transporter une certaine partie du fluide de refroidissement mis sous pression hors du premier volume d'impact (224a) et dans la deuxième chambre d'entrée (222b), et
(iii) le deuxième réseau de buses à microjet dans la plaque à jet (715b ; 817) est configuré pour recevoir le fluide de refroidissement mis sous pression en provenance de la deuxième chambre d'entrée (222b), accélérer le fluide de refroidissement mis sous pression, et diriger le fluide de refroidissement accéléré et mis sous pression pour qu'il s'écoule dans le second volume d'impact (224b) à haute vitesse pour frapper une deuxième portion de la surface de refroidissement de la plaque de base (212 ; 825 ; 1015 ; 1103), éliminant ainsi la chaleur que la deuxième portion de la surface de refroidissement a absorbé depuis ledit un ou lesdits plusieurs composants électroniques générateurs de chaleur.

2. Module de refroidissement de la revendication 1, comprenant en outre :
(a) un raccord de sortie (208 ; 620 ; 1055) relié au boîtier (206 ; 602 ; 1040 ; 1025) et configuré pour évacuer le fluide de refroidissement mis sous pression depuis le module de refroidissement ;
(b) un premier passage de collecte d'effluent (640) configuré pour capturer une certaine partie du fluide de refroidissement mis sous pression en provenance du premier volume d'impact (224a) et acheminer le fluide de refroidissement mis sous pression capturé jusqu'au raccord de sortie (208 ; 620 ; 1055) pour l'évacuation depuis le module de refroidissement.

3. Module de refroidissement de la revendication 2, comprenant en outre un second passage de collecte d'effluent (640) configuré pour capturer une certaine partie du fluide de refroidissement mis sous pression en provenance du second volume d'impact (224b) et acheminer le fluide de refroidissement mis sous pression capturé jusqu'au raccord de sortie (208 ; 620 ; 1055) pour l'évacuation depuis le module de refroidissement.

4. Module de refroidissement de la revendication 1, dans lequel le plafond (216 ; 630 ; 807) est fabriqué sous forme de composant monobloc du boîtier (206 ; 602 ; 1040 ; 1025).

5. Module de refroidissement de la revendication 1, dans lequel le plafond (216 ; 630 ; 807) n'est pas fabriqué sous forme de composant monobloc du boîtier (206 ; 602 ; 1040 ; 1025).

6. Module de refroidissement de la revendication 5, comprenant en outre :
(a) une plaque interstitielle (805 ; 910) disposée entre le boîtier (206 ; 602 ; 1040 ; 1025) et la plaque à jet (210a-210d ; 605 ; 815 ; 925 ; 1015) ;
(b) dans lequel le plafond (216 ; 630 ; 807) est fabriqué sous forme de composant monobloc de la plaque interstitielle.

7. Module de refroidissement de la revendication 1, comprenant en outre un joint d'étanchéité (635a ; 810 ; 1020) qui empêche le fluide de refroidissement mis sous pression entrant dans le premier segment de la plaque à jet (210a ; 605a ; 715a) de passer directement dans le deuxième segment de la plaque à jet (210b ; 605b ; 715b) sans s'écouler à travers le premier passage de transmission (214a ; 705a ; 705b ; 840).

8. Module de refroidissement de la revendication 1, dans lequel :
(a) le deuxième segment de la plaque à jet (210b ; 605b) entoure et enferme le premier segment de la plaque à jet (210a ; 605a) ;
(b) la deuxième limite montée sur plafond du plafond (218b ; 625b) entoure et enferme la première limite montée sur plafond (218a ; 625a) ; et
(c) la deuxième limite montée sur surface de refroidissement de la plaque de base (220b ; 830 ; 1110) entoure et enferme la première limite montée sur surface de refroidissement (220a ; 830 ; 1110).

9. Module de refroidissement de la revendication 1, dans lequel :
(a) la plaque à jet (210a-210d ; 605 ; 815 ; 925 ; 1015) comprend en outre un troisième segment (210c ; 605c ; 715c) qui inclut un troisième réseau de buses à microjet (715c ; 817) s'étendant à travers la plaque à jet depuis la face supérieure de la plaque à jet jusqu'à la face inférieure de la plaque à jet ;
(b) le plafond (216 ; 630 ; 807) comprend en outre une troisième limite montée sur plafond (218c) s'étendant depuis le plafond jusqu'à la face supérieure de la plaque à jet ; et
(c) la plaque de base (212 ; 610 ; 820 ; 930 ; 1010 ; 1105) comprend en outre une troisième limite montée sur surface de refroidissement (220c ; 830 ; 1110) s'étendant depuis la surface de refroidissement (212 ; 825 ; 1015 ; 1103) jusqu'à la face inférieure de la plaque à jet ;
(d) dans lequel la plaque à jet (210a-210d ; 605 ; 815 ; 925 ; 1015), le plafond (216 ; 630 ; 807), la surface de refroidissement de la plaque de base (212 ; 825 ; 1015 ; 1103), la première limite montée sur plafond (218a ; 625b), la deuxième limite montée sur plafond (218b ; 625b), la troisième limite montée sur plafond (218c), la première limite montée sur surface de refroidissement (220a ; 830 ; 1110), la deuxième limite montée sur surface de refroidissement (220b ; 830 ; 1110), et la troisième limite montée sur surface de refroidissement (220c ; 830 ; 1110) sont tous agencés pour définir une troisième chambre d'entrée (222c) située entre le plafond et le troisième réseau de buses à microjet (715c ; 817), un troisième volume d'impact (224c) situé entre la surface de refroidissement et le troisième réseau de buses à microjet, et un second passage de transmission (214b ; 705a, 705b ; 840 ; 935) relie fluidiquement soit le premier volume d'impact (224a) soit le second volume d'impact (224b), ou les deux, à la troisième chambre d'entrée ; et
(e) le troisième réseau de buses à microjet dans la plaque à jet (715c, 817) est configuré pour recevoir le fluide de refroidissement mis sous pression en provenance de la troisième chambre d'entrée (222c), accélérer le fluide de refroidissement mis sous pression, et diriger le fluide de refroidissement accéléré et mis sous pression pour qu'il s'écoule dans le troisième volume d'impact (224c) à haute vitesse pour frapper une troisième portion de la surface de refroidissement de la plaque de base (212 ; 825 ; 1015 ; 1103), éliminant ainsi la chaleur que la troisième portion de la surface de refroidissement a absorbé depuis ledit un ou lesdits plusieurs composants électroniques générateurs de chaleur.

10. Module de refroidissement de la revendication 9, comprenant en outre :
(a) un raccord de sortie (208 ; 620 ; 1055) relié au boîtier (206 ; 602 ; 1040 ; 1025) et configuré pour évacuer le fluide de refroidissement mis sous pression depuis le module de refroidissement ;
(b) un premier passage de collecte d'effluent (640 ; 740 ; 940) configuré pour capturer une certaine partie du fluide de refroidissement mis sous pression en provenance du troisième volume d'impact et acheminer le fluide de refroidissement mis sous pression capturé jusqu'au raccord de sortie pour l'évacuation depuis le module de refroidissement (224c).

11. Module de refroidissement de la revendication 9, comprenant en outre un joint d'étanchéité (635a ; 810 ; 1020) qui empêche le fluide de refroidissement mis sous pression entrant dans le premier segment de la plaque à jet (210a ; 605a ; 715a) de passer directement dans le deuxième segment de la plaque à jet (210b ; 605b ; 715b) sans s'écouler à travers le premier passage de transmission (214a ; 705a, 705b ; 840 ; 935).

12. Module de refroidissement de la revendication 11, dans lequel le joint d'étanchéité (635b ; 810 ; 1020) empêche le fluide de refroidissement mis sous pression entrant dans le deuxième segment de la plaque à jet (210b ; 605b ; 715b) de s'écouler directement dans le troisième segment de la plaque à jet (210c ; 605c ; 715c) sans s'écouler à travers le second passage de transmission (214b ; 705a, 705b ; 840 ; 935).

13. Module de refroidissement de la revendication 9, dans lequel :
(a) le troisième segment de la plaque à jet (210c ; 605c) entoure et enferme le premier segment (210a ; 605a) de la plaque à jet et le deuxième segment de la plaque à jet (210b ; 605b) ;
(b) la troisième limite montée sur plafond du plafond (218c) entoure et enferme la première limite montée sur plafond (218a ; 635a) et la deuxième limite montée sur plafond (218b ; 635b) ; et
(c) la troisième limite montée sur surface de refroidissement (220c ; 830 ; 1110) de la plaque de base entoure et enferme la première limite montée sur surface de refroidissement (220b ; 830 ; 1110) et la deuxième limite montée sur surface de refroidissement (220b ; 830 ; 1110).

14. Module de refroidissement de la revendication 9, dans lequel le plafond (216 ; 630 ; 807) est fabriqué sous forme de composant monobloc du boîtier (206 ; 602 ; 1040 ; 1025).

15. Module de refroidissement de la revendication 9, dans lequel le plafond (216 ; 630 ; 807) n'est pas fabriqué sous forme de composant monobloc du boîtier (206 ; 602 ; 1040 ; 1025).

16. Module de refroidissement de la revendication 15, comprenant en outre :
(a) une plaque interstitielle (805 ; 910) disposée entre le boîtier (206 ; 602 ; 1040 ; 1025) et la plaque à jet (210a-210d ; 605 ; 815 ; 925 ; 1015) ;
(b) dans lequel le plafond (216 ; 630 ; 807) est fabriqué sous forme de composant monobloc de la plaque interstitielle.

17. Module de refroidissement de la revendication 1, comprenant en outre :
(a) une seconde plaque à jet comprenant une autre face supérieure, une autre face inférieure, et un troisième segment (210c ; 605c) qui inclut un troisième réseau de buses à microjet (715c ; 817) s'étendant à travers la seconde plaque à jet depuis ladite autre face supérieure de la seconde plaque à jet jusqu'à ladite autre face inférieure de la seconde plaque à jet ;
(b) dans lequel
(i) le plafond (216 ; 630 ; 807) comprend en outre une troisième limite montée sur plafond (218c) s'étendant depuis le plafond jusqu'à ladite autre face supérieure de la seconde plaque à jet, et
(ii) la plaque de base (212 ; 610 ; 820 ; 930 ; 1010 ; 1105) comprend en outre une troisième limite montée sur surface de refroidissement (220c ; 830 ; 1110) s'étendant depuis la surface de refroidissement (212 ; 825 ; 1015 ; 1103) jusqu'à ladite autre face inférieure de la seconde plaque à jet,
(iii) dans lequel la seconde plaque à jet, le plafond (216 ; 630 ; 807), la surface de refroidissement de la plaque de base (212 ; 825 ; 1015 ; 1103), la première limite montée sur plafond (218a ; 625a), la deuxième limite montée sur plafond (218b ; 625b), la troisième limite montée sur plafond (218c), la première limite montée sur surface de refroidissement (220a ; 830 ; 1110), la deuxième limite montée sur surface de refroidissement (220b ; 830 ; 1110), et la troisième limite montée sur surface de refroidissement (220c ; 830 ; 1110) sont tous agencés pour définir une troisième chambre d'entrée (222c) située entre le plafond et le troisième réseau de buses à microjet (715c ; 817), un troisième volume d'impact (224c) situé entre la surface de refroidissement (212 ; 825 ; 1015 ; 1103) et le troisième réseau de buses à microjet, et un second passage de transmission (214b ; 705a ; 705b ; 840 ; 935) qui relie fluidiquement le premier volume d'impact (224a) ou le second volume d'impact (224b), ou les deux, à la troisième chambre d'entrée, et
(iv) le troisième réseau de buses à microjet dans la seconde plaque à jet (715c ; 817) est configuré pour recevoir le fluide de refroidissement mis sous pression en provenance de la troisième chambre d'entrée (222c), accélérer le fluide de refroidissement mis sous pression, et diriger le fluide de refroidissement accéléré et mis sous pression pour qu'il s'écoule dans le troisième volume d'impact (224c) à haute vitesse pour frapper une troisième portion de la surface de refroidissement de la plaque de base (212 ; 610 ; 820 ; 930 ; 1010 ; 1105), éliminant ainsi une certaine partie de la chaleur que la troisième portion de la surface de refroidissement a absorbé depuis ledit un ou lesdits plusieurs composants électroniques générateurs de chaleur.

18. Procédé pour refroidir un ou plusieurs composants électroniques générateurs de chaleur attachés à une carte de circuit imprimé, le procédé comprenant les étapes suivantes :
(a) fournir un module de refroidissement (200 ; 600 ; 800 ; 900 ; 1005) comprenant une plaque à jet (210a-210d ; 605 ; 815 ; 925 ; 1015), un boîtier (206 ; 602 ; 1040 ; 1025), un plafond (216 ; 630 ; 807) disposé entre la plaque à jet et le boîtier, une plaque de base (212 ; 610 ; 820 ; 930 ; 1010 ; 1105) ayant une surface de refroidissement (212 ; 825 ; 1015 ; 1103), et un système de fixation (1020, 1025, 1030) pour fixer le module de refroidissement à la carte de circuit imprimé ;
(b) dans lequel (i) la plaque à jet (210a-210d ; 605 ; 815 ; 925 ; 1015) comprend un premier segment (210a ; 605a ; Section 1A, Section 1B) qui inclut un premier réseau de buses à microjet (715a, 817) s'étendant à travers la plaque à jet, et un deuxième segment (210b ; 605b ; Section 2) qui inclut un deuxième réseau de buses à microjet (715b ; 817) s'étendant à travers la plaque à jet, et (ii) la plaque à jet, le plafond (216 ; 630 ; 807), la surface de refroidissement de la plaque de base (212 ; 825 ; 1015 ; 1103), une première limite montée sur plafond (218a ; 625a), une deuxième limite montée sur plafond (218b ; 625b), une première limite montée sur surface de refroidissement (220a ; 830 ; 1110) et une deuxième limite montée sur surface de refroidissement (220b ; 830 ; 1110) sont tous agencés pour définir une première chambre d'entrée (222a) située entre le plafond et le premier réseau de buses à microjet, une deuxième chambre d'entrée (222b) située entre le plafond et le deuxième réseau de buses à microjet, un premier volume d'impact (224a) situé entre le premier réseau de buses à microjet et la surface de refroidissement (212 ; 825 ; 1015 ; 1103), un second volume d'impact (224b) situé entre le deuxième réseau de buses à microjet et la surface de refroidissement, et un premier passage de transmission (214a ; 705a ; 705b ; 840) reliant fluidiquement le premier volume d'impact à la deuxième chambre d'entrée ;
(c) avec le système de fixation (1020, 1025, 1030), attacher le module de refroidissement (200 ; 600 ; 800 ; 900 ; 1005) à la carte de circuit imprimé de telle sorte que la surface de refroidissement de la plaque de base (212 ; 825 ; 1015 ; 1103) soit en communication thermique avec ledit un ou lesdits plusieurs composants électroniques générateurs de chaleur sur la carte de circuit imprimé et absorbe de la chaleur générée par ledit un ou lesdits plusieurs composants électroniques générateurs de chaleur alors que la carte de circuit imprimé est en fonctionnement ;
(d) relier une source externe pour un fluide de refroidissement mis sous pression à un orifice d'entrée (202 ; 615 ; 1050) sur le boîtier du module de refroidissement ;
(e) transmettre le fluide de refroidissement mis sous pression, reçu au niveau de l'orifice d'entrée (202 ; 615 ; 1050), dans la première chambre d'entrée de la plaque à jet (222a) ;
(f) avec le premier réseau de buses à microjet (715a ; 817) dans le premier segment de la plaque à jet (210a ; 605a ; Section 1A, Section 1B), recevoir le fluide de refroidissement mis sous pression en provenance de la première chambre d'entrée (222a), accélérer le fluide de refroidissement mis sous pression, et diriger le fluide de refroidissement accéléré et mis sous pression pour qu'il s'écoule dans le premier volume d'impact (224a) à haute vitesse pour frapper une première portion de la surface de refroidissement de la plaque de base (212 ; 825 ; 1015 ; 1103), éliminant ainsi la chaleur que la première portion de la surface de refroidissement a absorbé depuis ledit un ou lesdits plusieurs composants électroniques générateurs de chaleur ;
(g) avec le premier passage de transmission (214a ; 705a, 705b ; 840), transmettre une certaine partie du fluide de refroidissement mis sous pression, qui a frappé la première portion de la surface de refroidissement (212 ; 825 ; 1015 ; 1103), hors du premier volume d'impact (224a), dans la deuxième chambre d'entrée (222b) ; et
(h) avec le deuxième réseau de buses à microjet dans la plaque à jet (715b ; 817), recevoir le fluide de refroidissement mis sous pression en provenance de la deuxième chambre d'entrée (222b), accélérer le fluide de refroidissement mis sous pression, et diriger le fluide de refroidissement accéléré et mis sous pression pour qu'il s'écoule dans le second volume d'impact (224b) à haute vitesse pour frapper une deuxième portion de la surface de refroidissement de la plaque de base (212 ; 825 ; 1015 ; 1103) sans permettre au fluide de refroidissement mis sous pression de sortir du module de refroidissement (200 ; 600 ; 800 ; 900 ; 1005) avant d'entrer dans la deuxième chambre d'entrée, éliminant ainsi la chaleur que la deuxième portion de la surface de refroidissement a absorbé depuis ledit un ou lesdits plusieurs composants électroniques générateurs de chaleur.

19. Procédé de la revendication 18, comprenant en outre les étapes suivantes :
(a) capturer une certaine partie du fluide de refroidissement mis sous pression dans le premier volume d'impact (224a) que le premier passage de transmission (214a ; 705a, 705b ; 840 ; 935) ne transmet pas à la deuxième chambre d'entrée ;
(b) acheminer le fluide de refroidissement mis sous pression capturé jusqu'à un raccord de sortie (208 ; 620 ; 1055) relié au boîtier (206 ; 602 ; 1040 ; 1025) ; et
(c) évacuer le fluide de refroidissement mis sous pression depuis le module de refroidissement (200 ; 600 ; 800 ; 900 ; 1005).

20. Procédé de la revendication 18, dans lequel le plafond (216 ; 630 ; 807) est fabriqué sous forme de composant monobloc du boîtier (206 ; 602 ; 1040 ; 1025).

21. Procédé de la revendication 18, dans lequel le plafond (216 ; 630 ; 807) n'est pas fabriqué sous forme de composant monobloc du boîtier (206 ; 602 ; 1040 ; 1025).
